# EUROPEAN PATENT APPLICATION

(11) **EP 4 651 182 A1**
(43) Date of publication of application: **19.11.2025**
(21) Application number: 24747270.7
(22) Date of filing: 22.01.2024
(51) Int. Cl.: H01L 21/3065

(54) **SUBSTRATE PROCESSING METHOD AND SUBSTRATE PROCESSING SYSTEM**

(30) Priority: 27.01.2023 US 202363441559 P; 02.08.2023 JP 2023126394
(71) Applicant: Tokyo Electron Limited, Tokyo 107-6325 (JP)
(72) Inventor: ONO, Kenta, Kurokawa-gun, Miyagi 981-3629 (JP); FUJIMOTO, Seiji, Koshi City, Kumamoto 861-1116 (JP); OKADA, Soichiro, Koshi City, Kumamoto 861-1116 (JP); HARA, Arisa, Koshi City, Kumamoto 861-1116 (JP); SAKAGAMI, Takuya, Koshi City, Kumamoto 861-1116 (JP); NAKANE, Yuta, Kurokawa-gun, Miyagi 981-3629 (JP); KUMAKURA, Sho, Kurokawa-gun, Miyagi 981-3629 (JP); NISHIZUKA, Tetsuya, Kurokawa-gun, Miyagi 981-3629 (JP); HONDA, Masanobu, Kurokawa-gun, Miyagi 981-3629 (JP)
(74) Representative: Piotrowicz, Pawel Jan Andrzej
(86) International application number: PCT/JP2024/001705
(87) International publication number: WO 2024/157943

(57) **Abstract**

A disclosed substrate processing method includes providing a substrate on a substrate support in a chamber. The substrate has a metal-containing film including an exposed first region and an unexposed second region. The substrate processing method further includes exposing the substrate to BCl₃ gas and HBr gas to selectively remove the second region with respect to the first region to form a recess in the metal-containing film.

## Description

### Technical Field

Example embodiments of the present disclosure relate to a substrate processing method and a substrate processing system.

### Background Art

Patent Literature 1 discloses a technique for forming a thin film that is patterned using extreme ultraviolet light (hereinafter, referred to as "EUV") on a semiconductor substrate.

### Citation List

### Patent Literature

[Patent Literature 1] Japanese Unexamined Patent Publication No. 2021-523403

### Summary of Invention

### Technical Problem

The present disclosure provides a technology of appropriately developing a metal-containing film.

### Solution to Problem

In an example embodiment, a substrate processing method includes providing a substrate on a substrate support in a chamber. The substrate has a metal-containing film including an exposed first region and an unexposed second region. The substrate processing method further includes exposing the substrate to BCl₃ gas and HBr gas to selectively remove the second region with respect to the first region to form a recess in the metal-containing film.

### Advantageous Effects of Invention

According to the example embodiment of the present disclosure, a technology of appropriately developing a metal-containing film may be provided.

### Brief Description of Drawings

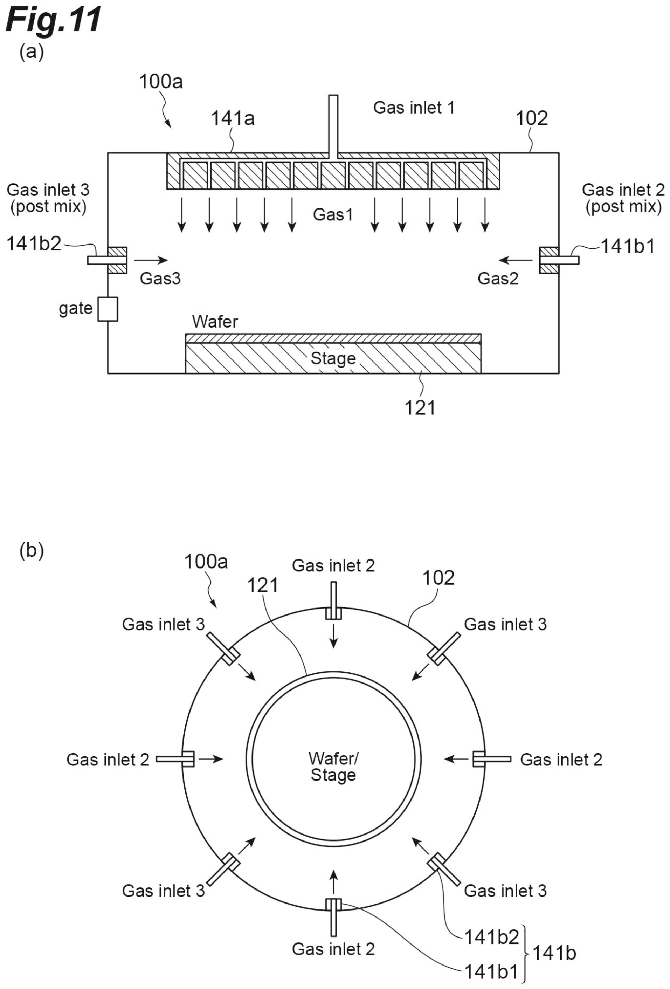

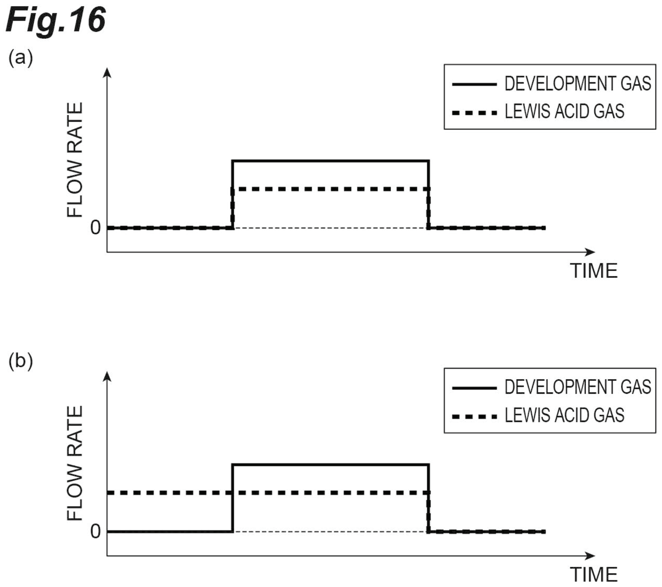

FIG. 1 is a diagram for describing a configuration example of a heat treatment system.
FIG. 2 is a diagram for describing a configuration example of a plasma processing system.
FIG. 3 is a diagram for describing a configuration example of a capacitively coupled plasma processing apparatus.
FIG. 4 is a flowchart showing a substrate processing method according to a first embodiment.
FIG. 5 is a diagram showing an example of a cross-sectional structure of a substrate W provided in an operation ST11 of the substrate processing method shown in FIG. 4.
FIG. 6 is a diagram showing an example of an underlying film UF of the substrate W.
FIG. 7 is a diagram showing an example of an underlying film UF of the substrate W.
(a) of FIG. 8 is a diagram showing an upper surface (a plane) and a cross section of a metal-containing film MF after exposure and (b) of FIG. 8 is a diagram showing an upper surface (a plane) and a cross section of a metal-containing film MF developed using a development gas in the related art.
(a) of FIG. 9 is a cross-sectional view of an example of a substrate including a protective portion, and (b) of FIG. 9 is a diagram for describing an effect of the protective portion in one embodiment.

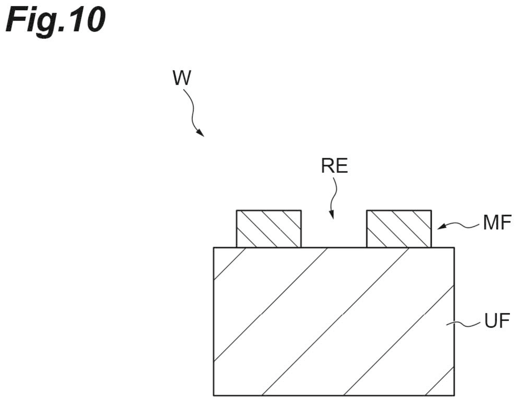

FIG. 10 is a diagram showing an example of a cross-sectional structure of the substrate W after development.
(a) of FIG. 11 is a schematic cross-sectional view showing another configuration example of the heat treatment system, and (b) of FIG. 11 is a schematic plan view showing another configuration example of the heat treatment system.

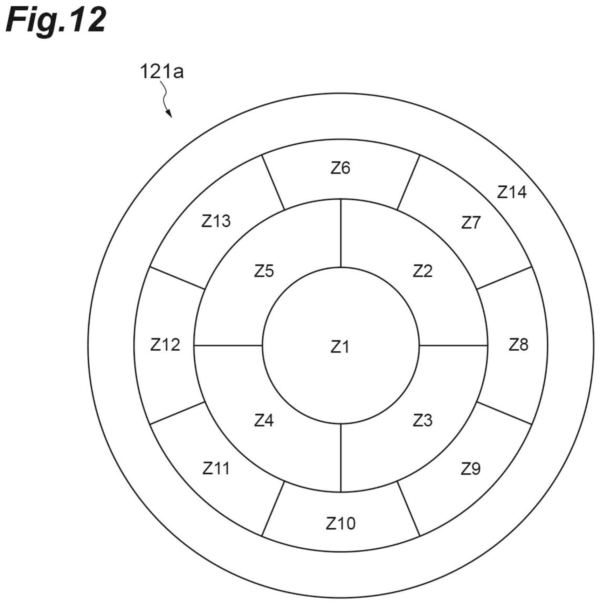

FIG. 12 is a schematic diagram showing a configuration example of a substrate support.

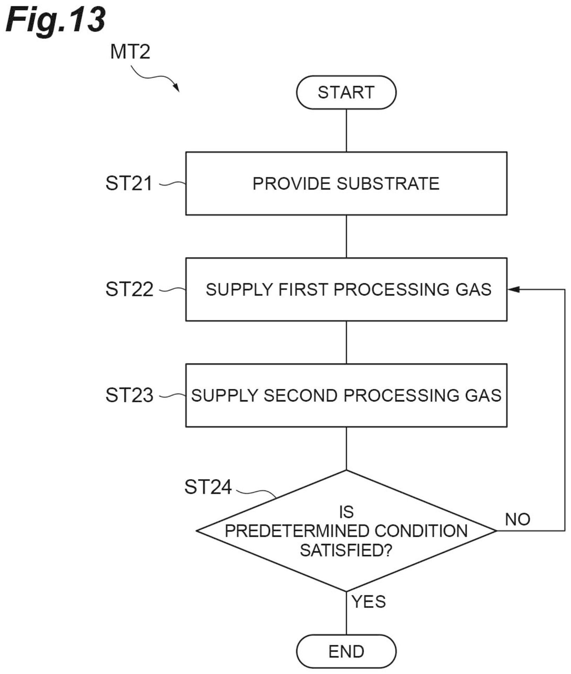

FIG. 13 is a flowchart showing a method MT2.

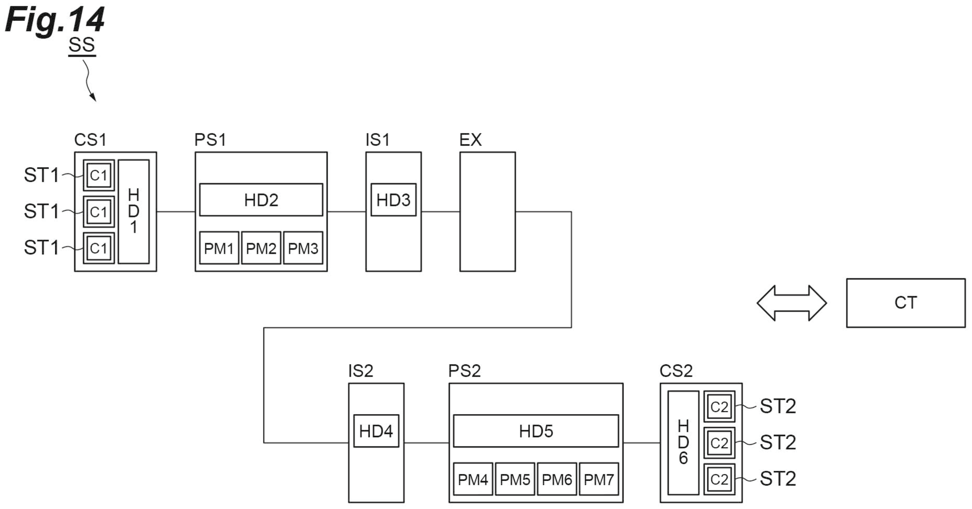

FIG. 14 is a block diagram for describing a configuration example of a substrate processing system SS.

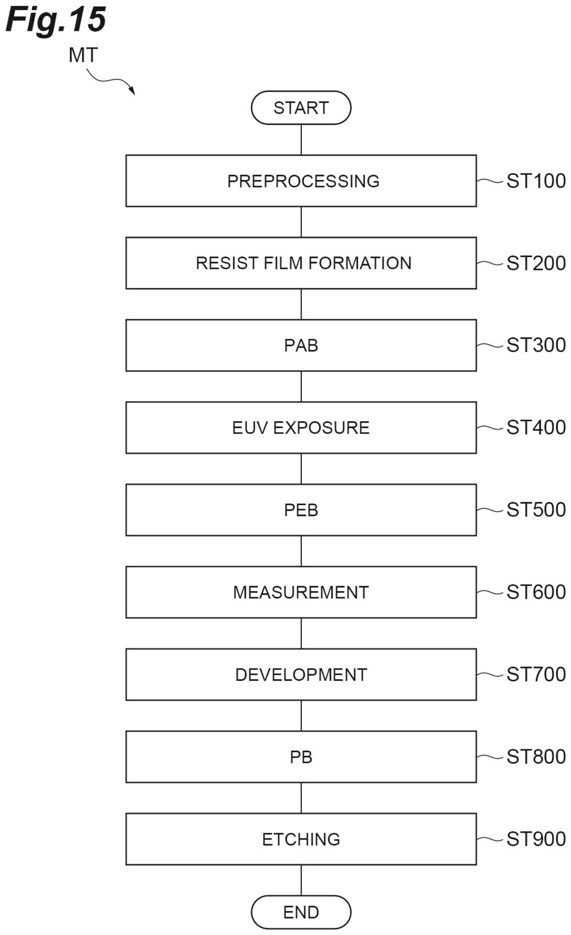

FIG. 15 is a flowchart showing a method MT.
(a) of FIG. 16 and (b) of FIG. 16 are timing charts of an example of development processing performed according to any one of a method MT1 and a method MT2.

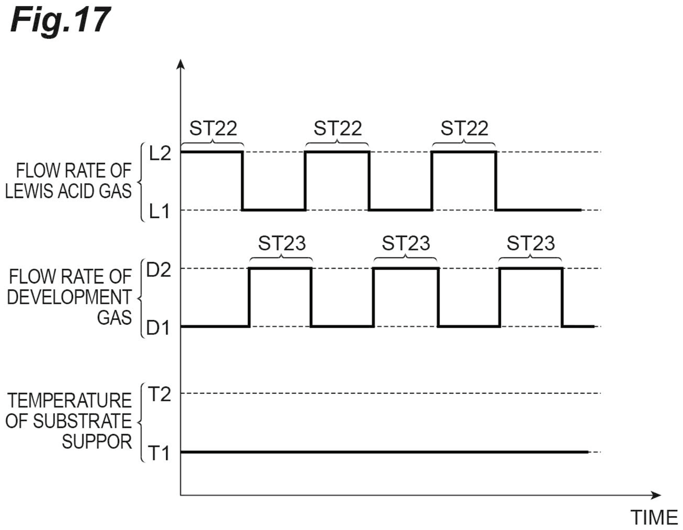

FIG. 17 is a timing chart of an example of development processing performed according to the method MT2.

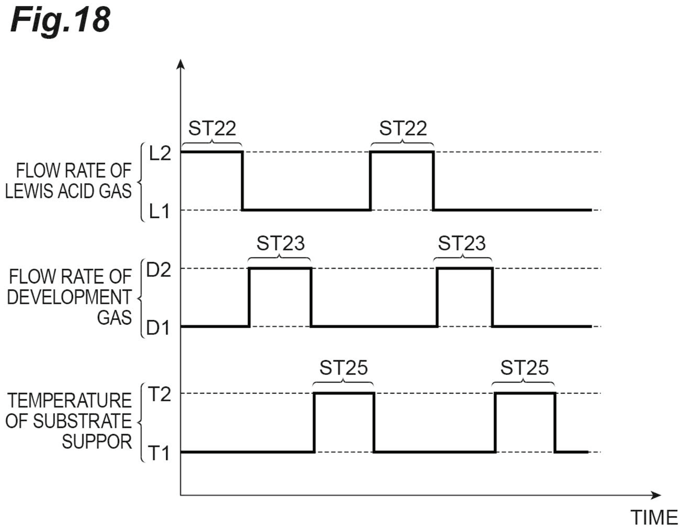

FIG. 18 is a timing chart of an example of development processing performed according to the method MT2.

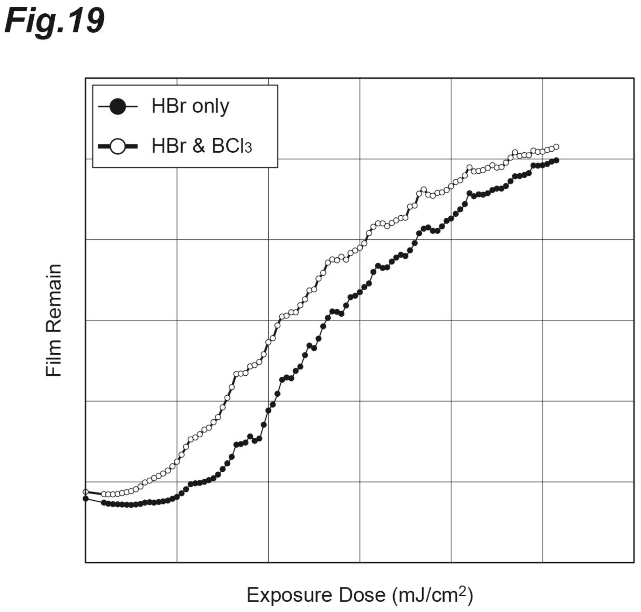

FIG. 19 is a graph showing a result of a first experiment.

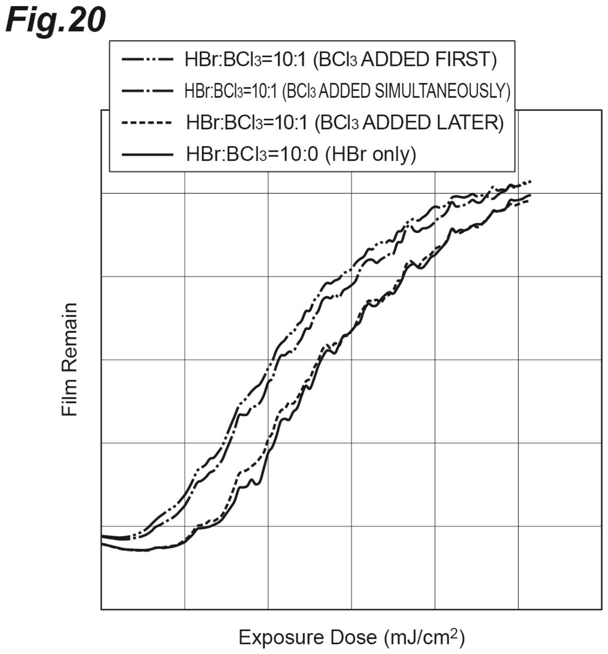

FIG. 20 is a graph showing a result of a second experiment.

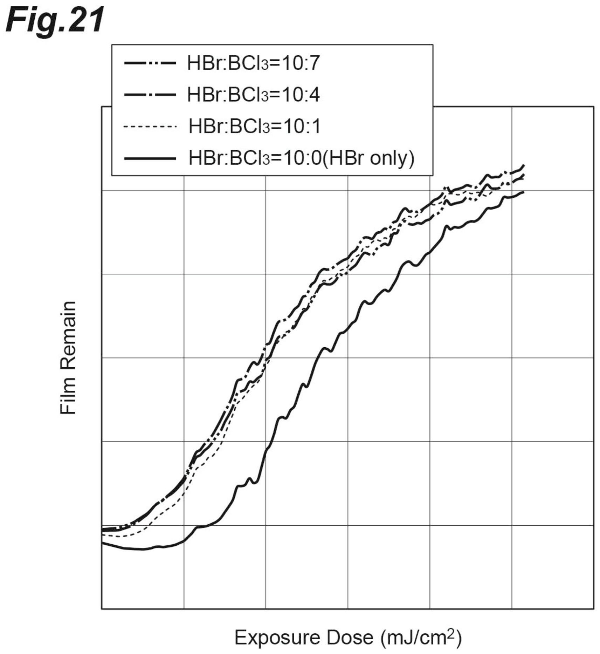

FIG. 21 is a graph showing a result of a third experiment.

### Description of Embodiments

A substrate processing method according to one example embodiment of the present disclosure includes (a) providing a substrate on a substrate support in a chamber, in which the substrate has a metal-containing film including an exposed first region and an unexposed second region, and (b) exposing the substrate to BCl₃ gas and HBr gas to selectively remove the second region with respect to the first region to form a recess in the metal-containing film.

Hereinafter, embodiments of the present disclosure will be described with reference to the drawings. The same or similar elements in the drawings are denoted by the same reference numerals, and the overlapping description will be omitted. Unless otherwise specifically described, the positional relationship such as up, down, left, and right will be described based on the positional relationship shown in the drawings. The dimensional ratios in the drawings do not indicate actual ratios, and the actual ratios are not limited to the shown ratios.

### <Configuration Example of Heat Treatment System>

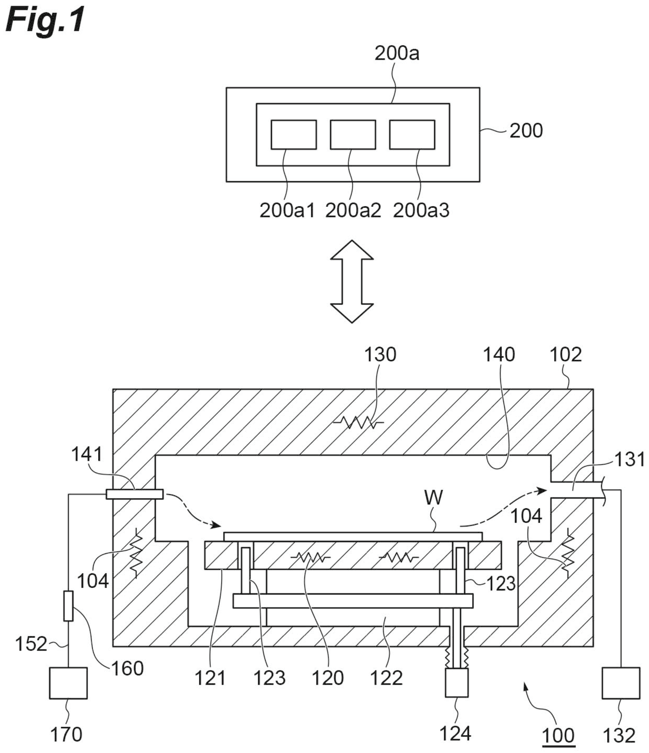

FIG. 1 is a diagram for describing a configuration example of a heat treatment system. In one embodiment, the heat treatment system includes a heat treatment apparatus 100 and a controller 200. The heat treatment system is an example of the substrate processing system, and the heat treatment apparatus 100 is an example of a substrate processing apparatus.

The heat treatment apparatus 100 has a processing chamber 102 that is configured to be sealable. The processing chamber 102 is, for example, an airtight cylindrical container, and is configured to be able to adjust the atmosphere inside. A side wall heater 104 is disposed in a side wall of the processing chamber 102. A ceiling heater 130 is disposed in a ceiling wall (ceiling plate) of the processing chamber 102. A ceiling surface 140 of the ceiling wall (ceiling plate) of the processing chamber 102 is formed as a horizontal flat surface, and a temperature thereof is adjusted by the ceiling heater 130.

A substrate support 121 is disposed on a lower side in the processing chamber 102. The substrate support 121 configures a placing portion on which the substrate W is placed. The substrate support 121 is formed, for example, in a circular shape in a plan view, and the substrate W is placed on a horizontally formed surface (upper surface) of the substrate support 121. A stage heater 120 is embedded in the substrate support 121. The stage heater 120 is capable of heating the substrate W placed on the substrate support 121. A ring assembly (not shown) may be disposed on the substrate support 121 to surround the substrate W. The ring assembly may include one or more annular members. By disposing the ring assembly around the substrate W, it is possible to improve the temperature controllability of an outer peripheral region of the substrate W. The ring assembly may be formed of an inorganic material or an organic material depending on the desired heat treatment.

The substrate support 121 is supported in the processing chamber 102 by a columnar support122 disposed on a bottom surface of the processing chamber 102. A plurality of lift pins 123 that can be vertically moved up and down are disposed on an outer side of the column 122 in a circumferential direction. Each of the plurality of lift pins 123 is inserted into a through-hole provided in the substrate support 121. The plurality of lift pins 123 are arranged at intervals in the circumferential direction. The lifting operation of the plurality of lift pins 123 is caused by a lift mechanism 124. In a case where the lift pin 123 protrudes from the surface of the substrate support 121, the substrate W can be delivered between a transfer mechanism (not shown) and the substrate support 121.

An exhaust port 131 having an opening is provided in a side wall of the processing chamber 102. The exhaust port 131 is connected to an exhaust mechanism 132 via an exhaust pipe. The exhaust mechanism 132 is provided with a vacuum pump, a valve, and the like, and adjusts an exhaust flow rate from the exhaust port 131. The pressure in the processing chamber 102 is adjusted by adjusting the exhaust flow rate and the like by means of the exhaust mechanism 132. A transfer port (not shown) of the substrate W is formed to be freely opened and closed, in the side wall of the processing chamber 102 at a position different from a position at which the exhaust port 131 is opened.

In addition, a gas nozzle 141 is disposed at a position in the side wall of the processing chamber 102, which is different from the positions of the exhaust port 131 and the transfer port of the substrate W. The gas nozzle 141 supplies the processing gas into the processing chamber 102. The gas nozzle 141 is disposed on a side opposite to the exhaust port 131 as viewed from a central portion of the substrate support 121, in the side wall of the processing chamber 102. That is, the gas nozzle 141 is disposed on the side wall of the processing chamber 102 symmetrically with respect to the exhaust port 131 on a vertical imaginary plane passing through the central portion of the substrate support 121.

The gas nozzle 141 is formed in a rod shape that protrudes from the side wall of the processing chamber 102 toward the center side of the processing chamber 102. A distal end portion of the gas nozzle 141 extends, for example, horizontally from the side wall of the processing chamber 102. The processing gas is discharged into the processing chamber 102 from a discharge port that is open at a distal end of the gas nozzle 141, flows in a direction of a one-dot chain line arrow shown in FIG. 1, and is exhausted from the exhaust port 131. The distal end portion of the gas nozzle 141 may have a shape extending obliquely downward toward the substrate W, or may have a shape extending obliquely upward toward the ceiling surface 140 of the processing chamber 102.

The gas nozzle 141 may be disposed, for example, in the ceiling wall of the processing chamber 102. In addition, the exhaust port 131 may be disposed in the bottom surface of the processing chamber 102.

The heat treatment apparatus 100 has a gas supply pipe 152 connected to the gas nozzle 141 from the outer side of the processing chamber 102. A pipe heater 160 for heating the gas in the gas supply pipe 152 is disposed around the gas supply pipe 152. The gas supply pipe 152 is connected to a gas supply 170. The gas supply 170 includes at least one gas source and at least one flow rate controller. The gas supply may include a vaporizer for vaporizing a material in a liquid state.

The controller 200 processes computer-executable instructions for causing the heat treatment apparatus 100 to perform various operations described in the present disclosure. The controller 200 may be configured to control each component of the heat treatment apparatus 100 to execute various operations described herein. In one embodiment, a part or all of the controller 200 may be included in the heat treatment apparatus 100. The controller 200 may include a processor 200a1, a storage 200a2, and a communication interface 200a3. The controller 200 is realized by, for example, a computer 200a. The processor 200a1 may be configured to read out a program from the storage 200a2 and execute the read out program to perform various control operations. This program may be stored in the storage 200a2 in advance, or may be acquired via the medium when necessary. The acquired program is stored in the storage 200a2, and is read out from the storage 200a2 and executed by the processor 200a1. The medium may be various storage media readable by the computer 200a, or may be a communication line connected to the communication interface 200a3. The processor 200a1 may be a central processing unit (CPU). The storage 200a2 may include a random access memory (RAM), a read only memory (ROM), a hard disk drive (HDD), a solid state drive (SSD), or combinations thereof. The communication interface 200a3 may be communicated with the heat treatment apparatus 100 via a communication line such as a local area network (LAN).

### <Configuration Example of Plasma Processing System>

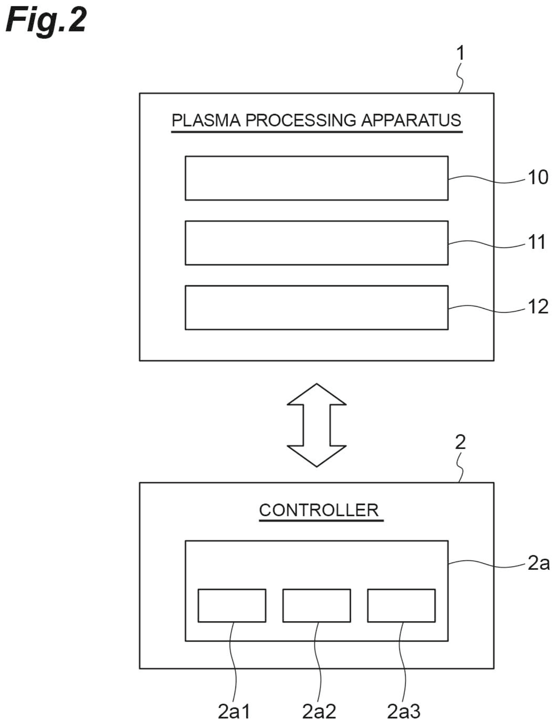

FIG. 2 is a diagram for describing a configuration example in a case where the plasma processing system is used as a development processing system. In an embodiment, a plasma processing system includes a plasma processing apparatus 1 and a controller 2. The plasma processing system is an example of a substrate processing system, and the plasma processing apparatus 1 is an example of a substrate processing apparatus. The plasma processing apparatus 1 includes a plasma processing chamber (hereinafter, also simply referred to as a "processing chamber") 10, a substrate support 11, and a plasma generator 12. The plasma processing chamber 10 has a plasma processing space. In addition, the plasma processing chamber 10 has at least one gas supply port for supplying at least one processing gas into the plasma processing space and at least one gas exhaust port for exhausting gases from the plasma processing space. The gas supply port is connected to a gas supply 20 described below and the gas exhaust port is connected to an exhaust system 40 described below. The substrate support 11 is disposed in the plasma processing space and has a substrate supporting surface for supporting a substrate.

The plasma generator 12 is configured to generate a plasma from the at least one processing gas supplied into the plasma processing space. The plasma formed in the plasma processing space may be a capacitively coupled plasma (CCP), an inductively coupled plasma (ICP), an electron-cyclotron-resonance (ECR) plasma, a helicon wave plasma (HWP), or a surface wave plasma (SWP), or the like. In addition, various types of plasma generators including an alternating current (AC) plasma generator and a direct current (DC) plasma generator may be used. In one embodiment, an AC signal (AC power) used in the AC plasma generator has a frequency in a range of 100 kHz to 10 GHz. Therefore, the AC signal includes a radio frequency (RF) signal and a microwave signal. In one embodiment, the RF signal has a frequency in a range of 100 kHz to 150 MHz.

The controller 2 processes computer-executable instructions for causing the plasma processing apparatus 1 to perform various operations described in the present disclosure. The controller 2 may be configured to control individual components of the plasma processing apparatus 1 to perform various operations described herein. In one embodiment, the functions of the controller 2 may be partially or entirely incorporated into the plasma processing apparatus 1. The controller 2 is implemented in, for example, a computer 2a. The controller 2 may include a processor 2a1, a storage 2a2, and a communication interface 2a3. Each component of the controller 2 may be the same as each component of the controller 200 described above (refer to FIG. 1).

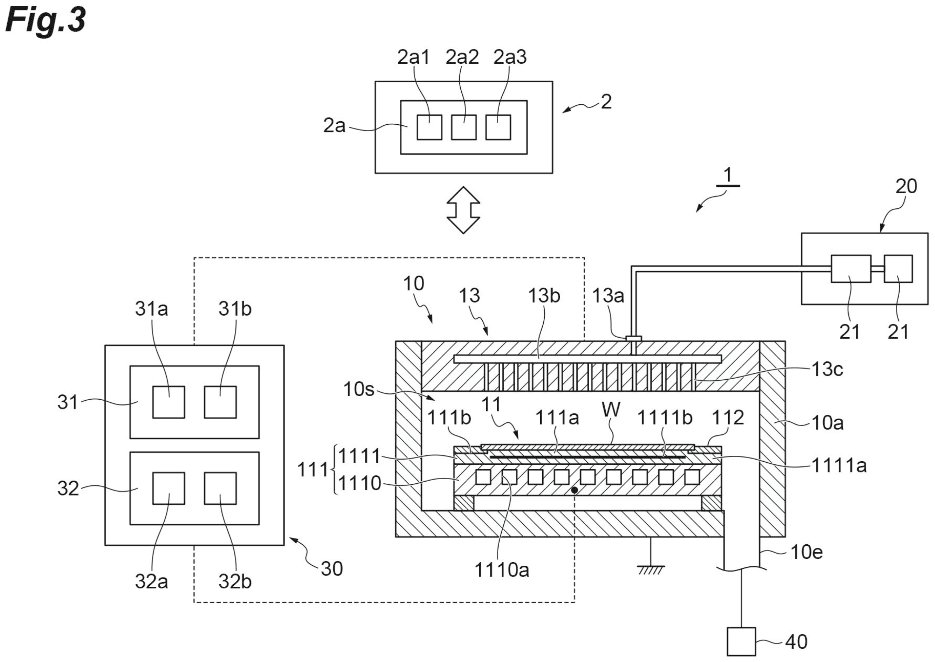

In the following, a configuration example of a capacitively coupled plasma processing apparatus, which is an example of the plasma processing apparatus 1, will be described. FIG. 3 is a diagram for describing a configuration example of a capacitively coupled plasma processing apparatus.

The capacitively coupled plasma processing apparatus 1 includes the plasma processing chamber 10, the gas supply 20, a power supply 30, and the exhaust system 40. In addition, the plasma processing apparatus 1 includes a substrate support 11 and a gas introduction unit. The gas introduction unit is configured to introduce at least one processing gas into the plasma processing chamber 10. The gas introduction unit includes a shower head 13. The substrate support 11 is disposed in the plasma processing chamber 10. The shower head 13 is disposed above the substrate support 11. In one embodiment, the shower head 13 constitutes at least a part of the ceiling of the plasma processing chamber 10. The plasma processing chamber 10 has a plasma processing space 10s that is defined by the shower head 13, a side wall 10a of the plasma processing chamber 10, and the substrate support 11. The plasma processing chamber 10 is grounded. The shower head 13 and the substrate support 11 are electrically insulated from a housing of the plasma processing chamber 10.

The substrate support 11 includes a body 111 and a ring assembly 112. The body 111 has a central region 111a for supporting the substrate W and an annular region 111b for supporting the ring assembly 112. A wafer is an example of the substrate W. The annular region 111b of the body 111 surrounds the central region 111a of the body 111 in a plan view. The substrate W is disposed on the central region 111a of the body 111, and the ring assembly 112 is disposed on the annular region 111b of the body 111 to surround the substrate W on the central region 111a of the body 111. Thus, the central region 111a is also referred to as a substrate supporting surface for supporting the substrate W, while the annular region 111b is also referred to as a ring supporting surface for supporting the ring assembly 112.

In one embodiment, the body 111 includes a base 1110 and an electrostatic chuck 1111. The base 1110 includes a conductive member. The conductive member of the base 1110 can function as a lower electrode. The electrostatic chuck 1111 is disposed on the base 1110. The electrostatic chuck 1111 includes a ceramic member 1111a and an electrostatic electrode 1111b disposed in the ceramic member 1111a. The ceramic member 1111a has the central region 111a. In one embodiment, the ceramic member 1111a also has the annular region 111b. Any other member, such as an annular electrostatic chuck or an annular insulating member, surrounding the electrostatic chuck 1111 may have the annular region 111b. In this case, the ring assembly 112 may be disposed on the annular electrostatic chuck or the annular insulating member, or may be disposed on both the electrostatic chuck 1111 and the annular insulating member. In addition, at least one RF/DC electrode coupled to an RF power supply 31 and/or a DC power supply 32 described below may be disposed in the ceramic member 1111a. In this case, the at least one RF/DC electrode functions as the lower electrode. In a case where a bias RF signal and/or a DC signal described below is supplied to the at least one RF/DC electrode, the RF/DC electrode is also referred to as a bias electrode. The conductive member of the base 1110 and the at least one RF/DC electrode may function as a plurality of lower electrodes. In addition, the electrostatic electrode 1111b may function as the lower electrode. Therefore, the substrate support 11 includes at least one lower electrode.

The ring assembly 112 includes one or more annular members. In one embodiment, the one or more annular members include one or more edge rings and at least one cover ring. The edge ring is formed of a conductive material or an insulating material, and the cover ring is formed of an insulating material.

In addition, the substrate support 11 may include a temperature adjusting module that is configured to adjust at least one of the electrostatic chuck 1111, the ring assembly 112, and the substrate to a target temperature. The temperature adjusting module may include a heater, a heat transfer medium, a flow path 1110a, or any combination thereof. A heat transfer fluid, such as brine or gas, flows into the flow path 1110a. In one embodiment, the flow path 1110a is formed in the base 1110, and one or more heaters are disposed in the ceramic member 1111a of the electrostatic chuck 1111. In addition, the substrate support 11 may further include a heat transfer gas supply configured to supply a heat transfer gas to a gap between a rear surface of the substrate W and the central region 111a.

The shower head 13 is configured to introduce at least one processing gas from the gas supply 20 into the plasma processing space 10s. The shower head 13 has at least one gas supply port 13a, at least one gas diffusion chamber 13b, and a plurality of gas introduction ports 13c. The processing gas supplied to the gas supply port 13a passes through the gas diffusion chamber 13b and is introduced into the plasma processing space 10s from the plurality of gas introduction ports 13c. In addition, the shower head 13 includes at least one upper electrode. The gas introduction unit may include one or more side gas injectors (SGI) attached to one or more openings formed in the side wall 10a, in addition to the shower head 13.

The gas supply 20 may include at least one gas source 21 and at least one flow rate control device 22. In one embodiment, the gas supply 20 is configured to supply the at least one processing gas from the corresponding gas source 21 through the corresponding flow rate controller 22 to the shower head 13. Each flow rate control device 22 may include, for example, a mass flow controller or a pressure-controlled flow rate controller. Further, the gas supply 20 may include at least one flow rate modulation device that modulates or pulses the flow rate of at least one processing gas.

The power supply 30 includes the RF power supply 31, which is coupled to the plasma processing chamber 10 via at least one impedance matching circuit. The RF power supply 31 is configured to supply at least one RF signal (RF power) to at least one lower electrode and/or at least one upper electrode. As a result, a plasma is formed from at least one processing gas supplied to the plasma processing space 10s. Therefore, the RF power supply 31 can function as at least a part of the plasma generator 12. In addition, by supplying the bias RF signal to at least one lower electrode, a bias potential is generated on the substrate W, and ionic components in the formed plasma can be drawn into the substrate W.

In one embodiment, the RF power supply 31 includes a first RF generator 31a and a second RF generator 31b. The first RF generator 31a is configured to be coupled to at least one lower electrode and/or at least one upper electrode via at least one impedance matching circuit, and is configured to generate a source RF signal (source RF power) for plasma generation. In one embodiment, the source RF signal has a frequency in a range of 10 MHz to 150 MHz. In one embodiment, the first RF generator 31a may be configured to generate a plurality of source RF signals having different frequencies. The generated one or plurality of source RF signals are supplied to at least one lower electrode and/or at least one upper electrode.

The second RF generator 31b is configured to be coupled to at least one lower electrode via at least one impedance matching circuit and is configured to generate a bias RF signal (bias RF power). The frequency of the bias RF signal may be the same as or different from the frequency of the source RF signal. In one embodiment, the bias RF signal has a frequency lower than the frequency of the source RF signal. In one embodiment, the bias RF signal has a frequency in a range of 100 kHz to 60 MHz. In one embodiment, the second RF generator 31b may be configured to generate a plurality of bias RF signals having different frequencies. The generated one or plurality of bias RF signals are supplied to at least one lower electrode. In addition, in various embodiments, at least one of the source RF signal and the bias RF signal may be pulsed.

In addition, the power supply 30 may include the DC power supply 32 coupled to the plasma processing chamber 10. The DC power supply 32 includes a first DC generator 32a and a second DC generator 32b. In one embodiment, the first DC generator 32a is configured to be connected to at least one lower electrode and is configured to generate a first DC signal. The generated first DC signal is applied to at least one lower electrode. In one embodiment, the second DC generator 32b is configured to be connected to at least one upper electrode and is configured to generate a second DC signal. The generated second DC signal is applied to at least one upper electrode.

In various embodiments, the first and second DC signals may be pulsed. In this case, a sequence of the voltage pulses is applied to at least one lower electrode and/or at least one upper electrode. The voltage pulses may have a pulse waveform of a rectangular, trapezoidal, triangular, or a combination thereof. In one embodiment, a waveform generator for generating the sequence of voltage pulses from the DC signal is connected between the first DC generator 32a and at least one lower electrode. Therefore, the first DC generator 32a and the waveform generator constitute a voltage pulse generator. In a case where the second DC generator 32b and the waveform generator constitute the voltage pulse generator, the voltage pulse generator is connected to at least one upper electrode. The voltage pulse may have a positive polarity or may have a negative polarity. Further, the sequence of the voltage pulses may include one or more positive-polarity voltage pulses and one or more negative-polarity voltage pulses in one cycle. The first and second DC generators 32a and 32b may be provided in addition to the RF power supply 31, or the first DC generator 32a may be provided instead of the second RF generator 31b.

The exhaust system 40 may be connected to, for example, a gas exhaust port 10e provided in a bottom of the plasma processing chamber 10. The exhaust system 40 may include a pressure regulating valve and a vacuum pump. The pressure in the plasma processing space 10s is adjusted by the pressure regulating valve. The vacuum pump may include a turbo molecular pump, a dry pump, or a combination thereof.

### <Substrate Processing Method>

Hereinafter, various embodiments of the substrate processing method in the present disclosure will be described.

### [First Embodiment]

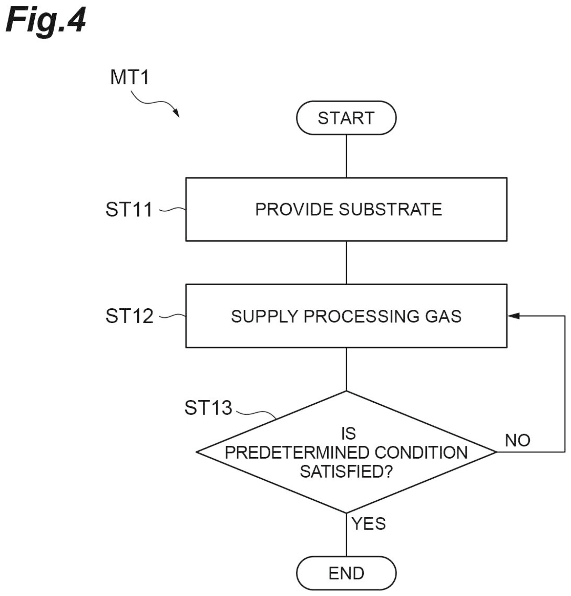

FIG. 4 is a flowchart showing a substrate processing method (hereinafter, also referred to as a "method MT1") according to the first embodiment. As shown in FIG. 4, the method MT1 includes an operation ST11 of providing a substrate and an operation ST12 of supplying a processing gas. The method MT1 may include an operation ST13 of determining whether or not a predetermined condition is satisfied after the operation ST12.

The method MT1 may be performed by using any one of the substrate processing systems described above (refer to FIGS. 1 to 3), or may be performed by using two or more of these substrate processing systems. For example, the method MT1 may be performed by a heat treatment system (refer to FIG. 1). In the following, the method MT1 will be described by taking a case where the controller 200 controls each component of the heat treatment apparatus 100 to apply the method MT1 to the substrate W, as an example.

### (Operation ST11: Provision of Substrate)

First, in the operation ST11, the substrate W is provided in the processing chamber 102 of the heat treatment apparatus 100. The substrate W is provided on the substrate support 121 via the lift pin 123. After the substrate W is disposed on the substrate support 121, the temperature of the substrate support 121 is adjusted to a set temperature. The temperature of the substrate support 121 may be adjusted by controlling the output of one or more heaters of the side wall heater 104, the stage heater 120, the ceiling heater 130, and the pipe heater 160 (hereinafter, also collectively referred to as "each heater"). In the method MT1, the temperature of the substrate support 121 may be adjusted to the set temperature before the operation ST11. That is, after the temperature of the substrate support 121 is adjusted to the set temperature, the substrate W may be provided on the substrate support 121.

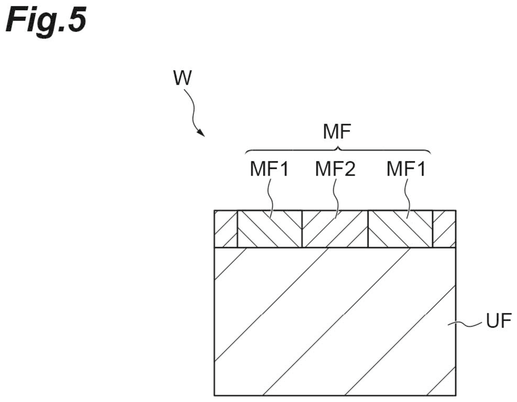

FIG. 5 is a diagram showing an example of a cross-sectional structure of a substrate W provided in the operation ST11 of the substrate processing method shown in FIG. 4. The substrate W includes the underlying film UF and the metal-containing film MF formed on the underlying film UF. The substrate W may be used for manufacturing a semiconductor device. The semiconductor device includes, for example, a memory device such as a DRAM or a 3D-NAND flash memory, and a logic device.

The metal-containing film MF is a metal-containing resist film that contains a metal. In one example, the metal may include at least one metal selected from the group consisting of Sn (tin), Hf (hafnium), and Ti (titanium). In one example, the metal-containing film MF may contain Sn, and may contain tin oxide (Sn-O bond) and/or tin hydroxide (Sn-OH bond). The metal-containing film MF may further contain an organic substance.

As shown in FIG. 5, the metal-containing film MF has an exposed first region MF1 and an unexposed second region MF2. The first region MF1 may be an exposure region exposed to the EUV light. The second region MF2 may be an unexposed region that is not exposed to the EUV light.

The underlying film UF may be an organic film, a dielectric film, a metal film, a semiconductor film, or a laminated film of these, formed on a silicon wafer.

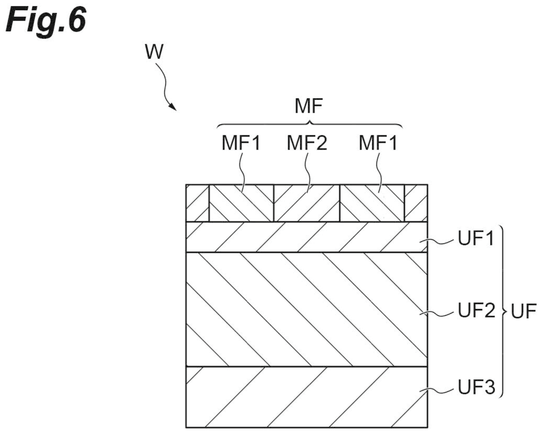

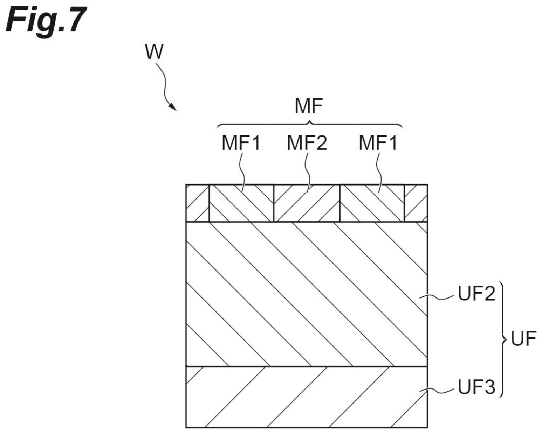

FIGS. 6 and 7 are diagrams showing examples of the underlying film UF of the substrate W, respectively. As shown in FIG. 6, the underlying film UF may be made of a first film UF 1, a second film UF2, and a third film UF3. In addition, as shown in FIG. 7, the underlying film UF may be made of a second film UF2 and a third film UF3.

The first film UF1 is, for example, a spin-on glass (SOG) film, a SiC film, a SiON film, a Si-containing anti-reflective coating (SiARC) film, or an organic film. The second film UF2 is, for example, a spin-on carbon (SOC) film, an amorphous carbon film, or a silicon-containing film. The third film UF3 is, for example, a silicon-containing film. The silicon-containing film is, for example, a silicon oxide film, a silicon nitride film, a silicon oxynitride film, a silicon carbon nitride film, a polycrystalline silicon film, or a carbon-containing silicon film. The third film UF3 may be made of a plurality of types of laminated silicon-containing films. For example, the third film UF3 may be made of a silicon oxide film and a silicon nitride film which are alternately laminated. In addition, the third film UF3 may be made of a silicon oxide film and a polycrystalline silicon film which are alternately laminated. In addition, the third film UF3 may be a laminated film including a silicon nitride film, a silicon oxide film, and a polycrystalline silicon film. In addition, the third film UF3 may be made of a laminated silicon oxide film and silicon carbon nitride film. In addition, the third film UF3 may be a laminated film including a silicon oxide film, a silicon nitride film, and a silicon carbon nitride film.

In one embodiment, the substrate W is formed as follows. First, a photoresist film containing a metal is formed on an underlying film which has been subjected to an adhesion improving processing or the like. The film formation may be performed by a dry process, a wet process such as a solution coating method, or both the dry process and the wet process. Before forming the photoresist film, surface reforming processing of the underlying film may be performed. The substrate after the formation of the photoresist film is subjected to a heating treatment, that is, a pre bake (post apply bake (PAB)). An additional heating treatment may be performed after the pre bake. The substrate after the heating treatment is transferred to an exposure device, and the photoresist film is irradiated with EUV light via an exposure mask (reticle). As a result, the substrate W including the underlying film UF and the metal-containing film MF having the exposed first region MF1 and the unexposed second region MF2 is formed. The first region MF1 is a region corresponding to an opening provided in the exposure mask (reticle). The second region MF2 is a region corresponding to a pattern (non-opening region) for shielding EUV light provided in the exposure mask (reticle). The EUV has, for example, a wavelength in the range of 10 nm to 20 nm. The EUV may have a wavelength in the range of 11 nm to 14 nm, and has a wavelength of 13.5 nm in one example. The substrate W after the exposure is transferred from the exposure device to the heat treatment apparatus under atmosphere control, and is subjected to a heating treatment, that is, a post exposure bake (PEB). After the PEB, the substrate W may be subjected to an additional heating treatment.

### (Operation ST12: Supply of Processing Gas)

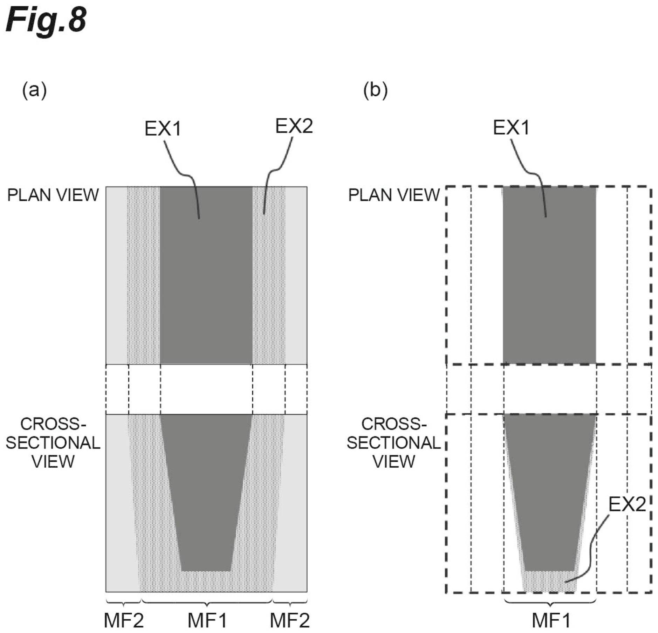

In the operation ST12, the substrate is exposed to the processing gas to selectively remove the second region MF2 with respect to the first region MF1. That is, in the operation ST12, the metal-containing film MF is developed by using the processing gas. In the first region MF1 of the metal-containing film MF, as shown in (a) of FIG. 8, a high exposure region EX1 and an intermediate exposure region EX2 may be present. The high exposure region EX1 is a region at the central portion of the first region MF1 and in the vicinity of the central portion of the first region MF1, where the exposure dose is sufficient. That is, the high exposure region EX1 is a region that is irradiated with a sufficient amount of light during the exposure of the substrate W. On the other hand, the intermediate exposure region EX2 is a region closer to the second region MF2 than the high exposure region EX1, and is a region where the exposure dose is insufficient. That is, the intermediate exposure region EX2 is a region in which the amount of light irradiated during the exposure of the substrate W is insufficient. Since a development gas such as HBr gas has high reactivity, the selectivity, which is a difference between the development speed of the first region MF1 and the development speed of the second region MF2, is low in a case where the development gas such as HBr gas is used. Therefore, in a case where the metal-containing film MF is developed using the development gas such as HBr, not only the high exposure region EX1 but also the intermediate exposure region EX2 may be removed, and the shape of the first region MF1 after development may deteriorate. For example, as shown in (b) of FIG. 8, a dimension (line width) of the first region MF1 may be reduced due to development, and the cross-sectional shape may be an inverse tapered shape.

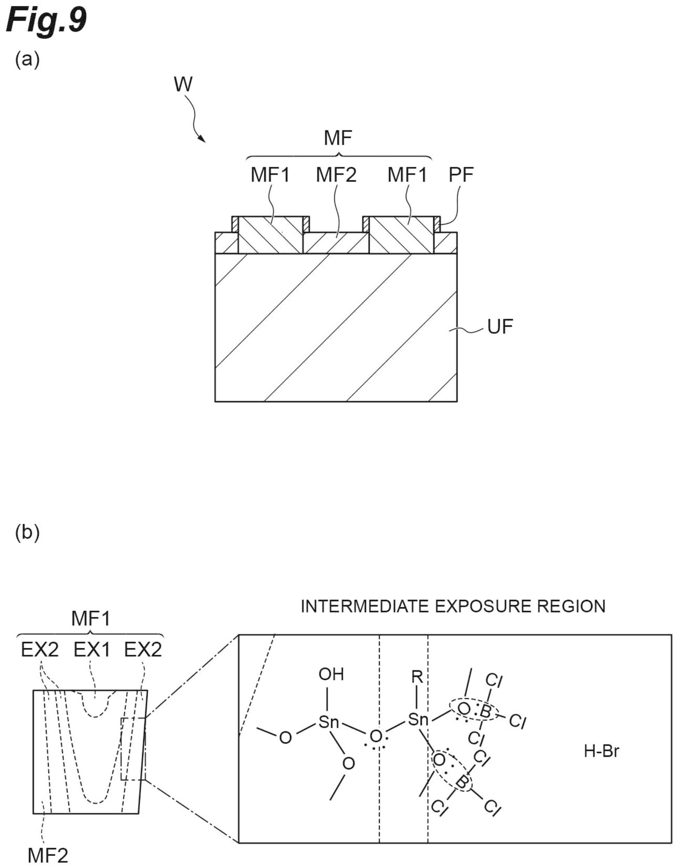

On the other hand, when the dry development is performed on the metal-containing film MF in the operation ST12, a processing gas including a gas including a Lewis acid and a development gas is used. That is, in the operation ST12, the processing gas including a Lewis acid gas and a development gas is used. According to the operation ST12 using such a processing gas, a surface of the first region MF1 (intermediate exposure region) exposed by the dry development reacts with the Lewis acid, and a protective portion PF is formed on the surface of the first region MF1, as shown in (a) of FIG. 9. The surface on which the protective portion PF is formed includes a side wall that defines a recess formed in the operation ST12. (b) of FIG. 9 is a diagram for describing an effect of the protective portion PF in one embodiment. (b) of FIG. 9 shows an example of a case where dry development is performed on the metal-containing film MF containing Sn using a processing gas containing BCl₃ gas as a gas containing a Lewis acid and HBr gas as a development gas. As shown in (b) of FIG. 9, an Sn-O bond is present on the surface of the first region MF1 exposed by the dry development, and in a case where the surface is brought into contact with BCl₃ gas, an O-B bond is formed, which inhibits the contact between the surface of the first region MF1 and HBr gas. That is, the contact between the surface of the first region MF1 and the HBr gas is inhibited by the protective portion containing boron or a region containing a bond of boron and oxygen. As a result, as shown in FIG. 10, the recess RE can be formed by development while suppressing the reaction between the first region MF1 and the development gas, and the shape of the first region MF1 after development can be made close to a vertical shape. That is, according to the operation ST12, the shape of the side wall of the first region MF1 can be made close to the vertical shape. In addition, according to the operation ST12, it is possible to suppress the reduction in the dimension (line width) of the first region MF1 due to the development. As a result, according to the method MT1, it is possible to reduce the exposure dose required to obtain the desired dimension (for example, a line width). That is, according to the method MT1, it is possible to improve the sensitivity. In addition, according to the method MT1, the roughness of the developed metal-containing film MF, for example, a line width roughness (LWR) can be reduced.

In one embodiment, the gas containing a Lewis acid may include, for example, at least one selected from the group consisting of BX₃, AlX₃, FeX₃, GaX₃, SbX₅, InX₃, SO₂, and SO₃. Here, X is at least one selected from F, Cl, Br, I, H, R, and OR, and R is Me, Et, Pr, i-Pr, Bu, i-Bu, s-Bu, t-Bu, or the like. That is, R is a methyl group, an ethyl group, a propyl group, a butyl group, an isopropyl group, an isobutyl group, a sec-butyl group, or a tert-butyl group. In addition, OR is a methoxy group, an ethoxy group, a propoxy group, a butoxy group, an isopropoxy group, an isobutoxy group, a sec-butoxy group, or a tert-butoxy group. In addition, the development gas may be a gas containing at least one selected from the group consisting of HBr, HCl, and a carboxylic acid. In one example of the operation ST12, BCl₃ gas can be used as the gas containing a Lewis acid, and HBr gas can be used as the development gas. In the operation ST12 of this example, the BCl₃ gas and the HBr gas may be supplied at the same time.

In one embodiment, a flow rate of the gas containing a Lewis acid in the processing gas may be less than a flow rate of the development gas. For example, in a case where the BCl₃ gas and the HBr gas are used as the processing gas, a value of a ratio of a flow rate of the BCl₃ gas to a flow rate of the HBr gas may be controlled in a range of 0.1 or more and 0.7 or less. In a case where the value of the ratio of the flow rate of the gas containing BCl₃ to the flow rate of HBr is 0.1 or more, the above-described effects can be sufficiently obtained. On the other hand, in a case where a value of a ratio of the flow rate of the gas containing a Lewis acid to a flow rate of the development gas is 0.7 or less, the deterioration of roughness and/or the development defects such as scum can be sufficiently suppressed. In a period in which the operation ST12 is performed, the ratio of the flow rate of the gas containing a Lewis acid to the flow rate of the development gas may be changed. For example, depending on the aspect ratio of the recess formed in the operation ST12, the ratio of the flow rate of the gas containing the Lewis acid to the flow rate of the development gas may be increased or decreased.

In one embodiment, during the operation ST12, a temperature of the substrate support 121 may be controlled to a given temperature. For example, in a case where BCl₃ gas and HBr gas are used as the processing gas, the temperature of the substrate support 121 may be controlled to 120°C or lower or 100°C or lower in a period in which the operation ST12 is performed. In a case where the temperature of the substrate support 121 is 120°C or lower or 100°C or lower, a high selectivity can be obtained, a high verticality of the shape of the first region MF1 after development can be obtained, and a decrease in the dimension (line width) of the first region MF1 due to development can be suppressed.

### (Operation ST13: Determination)

The method MT1 may include the operation ST13 of determining whether or not the substrate W after the operation ST12 satisfies a predetermined condition. The predetermined condition may be the removal amount of the second region MF2, may be the presence or absence of the exposure of the underlying film UF, or may be the processing time in the operation ST12. In a case where it is determined in the operation ST13 that the predetermined condition is not satisfied (in a case where the determination result in the operation ST13 of FIG. 4 is "NO"), the operation ST12 may be performed again. On the other hand, in a case where it is determined in the operation ST13 that the predetermined condition is satisfied (in a case where the determination result in the operation ST13 of FIG. 4 is "YES"), the method MT1 may end.

### [Second Embodiment]

The heat treatment system may include a heat treatment apparatus 100a shown in (a) of FIG. 11 and (b) of FIG. 11 instead of the heat treatment apparatus 100 shown in FIG. 1. (a) of FIG. 11 is a schematic cross-sectional view showing a configuration example of the heat treatment apparatus 100a, and (b) of FIG. 11 is a schematic plan view showing a configuration example of the heat treatment apparatus 100a. The heat treatment apparatus 100a includes a shower head 141a and a plurality of gas nozzles 141b on a side wall. The shower head 141a is disposed in a ceiling of the processing chamber 102. The shower head 141a may be disposed to face the substrate support 121. The plurality of gas nozzles 141b are provided in the side wall of the processing chamber 102. The plurality of gas nozzles 141b may be disposed, for example, at equal intervals along a circumferential direction on the side wall of the processing chamber 102. The plurality of gas nozzles 141b may include a first gas nozzle 141b1 and a second gas nozzle 141b2. The first gas nozzle 141b1 and the second gas nozzle 141b2 may be alternately disposed along the circumferential direction. The types of gases supplied into the processing chamber 102 from the shower head 141a, the first gas nozzle 141b1, and the second gas nozzle 141b2 may be the same as or different from each other. In addition, the flow rates of the gases supplied into the processing chamber 102 from the shower head 141a, the first gas nozzle 141b1, and the second gas nozzle 141b2 may be the same as or different from each other. A heater (not shown) may be disposed in each of the substrate support 121 and the side wall of the processing chamber 102 in the same manner as the heat treatment apparatus 100. In addition, a gas exhaust port (not shown) may be disposed on a bottom surface side of the processing chamber 102.

According to the heat treatment apparatus 100a, the gas density in the processing chamber 102 can be easily controlled, and the in-plane uniformity in the development of the metal-containing film MF can be improved.

### [Third Embodiment]

As the substrate support, a substrate support 121a shown in FIG. 12 may be used instead of the substrate support 121 shown in FIG. 1. The substrate support 121a shown in FIG. 12 has a plurality of zones, and each zone is provided with a heater electrode. The plurality of zones are arranged along a surface orthogonal to a central axis of the substrate support 121a or a surface parallel to the substrate W. In the example shown in FIG. 12, the substrate support 121a has zones Z1 to Z14, and each zone is provided with a heater electrode. The heater electrodes in each zone are configured such that power can be supplied independently to each heater electrode. That is, the substrate support 121a is configured to independently control the temperature for each zone. According to the substrate support 121a, the in-plane uniformity in the development of a metal-containing film MF can be improved.

### [Fourth Embodiment]

The method MT1 may be performed using the plasma processing apparatus 1 instead of the heat treatment apparatus 100a. In this case, in the operation ST12, the substrate W is exposed to the plasma generated from the processing gas in the plasma processing apparatus 1, and thus the second region may be selectively removed with respect to the first region. The processing gas may be the same as the processing gas in the first embodiment.

### [Fifth Embodiment]

In the substrate processing method according to the present disclosure, a precoat may be performed on the side wall of the processing chamber 102 and/or the parts (hereinafter, also referred to as "in-chamber parts") in the processing chamber 102, such as the substrate support 121, before the start of the substrate processing (development). The precoat may be performed by an atomic layer deposition method (hereinafter, also referred to as an "ALD method"), a chemical vapor deposition method (hereinafter, also referred to as a "CVD method"), or the like. As the gas for forming the precoat film, a gas capable of forming a film having resistance to a processing gas containing at least one selected from the group consisting of HBr, HCl, carboxylic acid, and a Lewis acid gas may be selected. As described above, the Lewis acid gas may contain at least one selected from the group consisting of BX₃, AlX₃, FeX₃, GaX₃, SbX₅, InX₃, SO₂, and SO₃. As the gas for forming the precoat film, for example, a silicon-containing gas such as aminosilane or SiCl₄ can be used. In this case, a silicon oxide film can be formed as a precoat film on the side wall of the processing chamber 102 and/or the in-chamber parts. Accordingly, it is possible to suppress the corrosion of the side wall of the processing chamber 102 and/or the substrate support 121 or the like due to the processing gas.

In addition, instead of the precoat or together with the precoat, the side wall of the processing chamber 102 and/or the in-chamber parts may be made of a material having resistance to a processing gas containing at least one selected from the group consisting of HBr, HCl, carboxylic acid, and the Lewis acid gas. As described above, the Lewis acid gas may contain at least one selected from the group consisting of BX₃, AlX₃, FeX₃, GaX₃, SbX₅, InX₃, SO₂, and SO₃.

In addition, in the substrate processing method according to the present disclosure, the inside of the processing chamber 102 may be cleaned after the substrate processing (development). In this case, the cleaning gas may be supplied into the processing chamber 102, and cleaning may be performed by heat. For example, a cleaning gas may be supplied into the processing chamber 102 while heating the processing chamber 102 and the in-chamber parts. Alternatively, a cleaning gas may be supplied into the processing chamber 102, and cleaning may be performed by plasma generated from the cleaning gas. The cleaning gas may contain at least one of H₂, HBr, HCl, BCl₃, Cl₂, CH₃OH, C₂H₅OH, CH₄, O₂, and the like, or may include an inert gas such as Ar and/or N₂. Alternatively, the cleaning may be performed by a thermal atomic layer etching method (hereinafter, also referred to as a "thermal ALE method"). For example, the cleaning may be performed by a thermal atomic layer etching method in which a fluorine-containing gas and a chlorine-containing gas are alternately supplied. Accordingly, it is possible to remove the metal oxide attached to the side wall of the processing chamber 102 and/or the in-chamber parts during development.

### [Sixth Embodiment]

In the substrate processing method according to the sixth embodiment, the underlying film UF is etched using the metal-containing film MF developed by the method MT1 as a mask. The etching conditions for the underlying film UF may be selected based on the film type of the underlying film UF or the like. In one embodiment, the etching of the underlying film UF may be performed by the plasma processing apparatus 1 shown in FIG. 3.

### [Seventh Embodiment]

FIG. 13 is a flowchart showing a substrate processing method (hereinafter, also referred to as a "method MT2") according to the second embodiment. In an operation ST21 of the method MT2, the substrate is provided in the same manner as in the operation ST11. The substrate may be the same as the substrate W of the first embodiment. In the method MT2, a first processing gas including a gas containing a Lewis acid is supplied into the processing chamber 102 in a subsequent operation ST22, and a second processing gas including a development gas is supplied into the processing chamber 102 in an operation ST23. That is, the method MT2 is different from the method MT1 in that the method MT2 includes supplying a gas containing a Lewis acid into the processing chamber 102 prior to supply of the development gas, and then supplying the development gas. The second processing gas may further include a gas containing a Lewis acid. The method MT2 may have an operation ST24 of determining whether or not a predetermined condition is satisfied after the operation ST23.

In one embodiment, the gas containing a Lewis acid (Lewis acid gas) in the method MT2 may be the same as the gas containing a Lewis acid in the method MT1. In addition, the development gas in the method MT2 may be the same as the development gas in the method MT1.

A flow rate of the gas containing a Lewis acid in the second processing gas may be less than a flow rate of the development gas. For example, in a case where the BCl₃ gas and the HBr gas are used as the second processing gas, a value of a ratio of a flow rate of the BCl₃ gas to a flow rate of the HBr gas in the second processing gas may be controlled in a range of 0.1 or more and 0.7 or less. In a case where the value of the ratio of the flow rate of the gas containing BCl₃ to the flow rate of HBr gas is 0.1 or more, the above-described effects can be sufficiently obtained. On the other hand, in a case where a value of a ratio of the flow rate of the gas containing a Lewis acid to a flow rate of the development gas is 0.7 or less, the deterioration of roughness and/or the development defects such as scum can be sufficiently suppressed. In a period in which the operation ST23 is performed, the ratio of the flow rate of the gas containing a Lewis acid to the flow rate of the development gas may be changed. For example, depending on the aspect ratio of the recess formed in the operation ST23, the ratio of the flow rate of the gas containing the Lewis acid to the flow rate of the development gas may be increased or decreased.

The first processing gas may include the development gas in addition to the gas containing a Lewis acid. In this case, the flow rate of the development gas in the first processing gas may be less than the flow rate of the gas containing a Lewis acid.

In one embodiment, the temperature of the substrate support 121 may be controlled to a given temperature during the operation ST22 and the operation ST23. For example, in a case where BCl₃ gas is used as the first processing gas and BCl₃ gas and HBr gas are used as the second processing gas, the temperature of the substrate support 121 may be controlled to 120°C or lower or 100°C or lower in a period in which the operation ST22 and the operation ST23 are performed. In a case where the temperature of the substrate support 121 is 120°C or lower or 100°C or lower, a high selectivity can be obtained, a high verticality of the shape of the first region MF1 after development can be obtained, and a decrease in the dimension (line width) of the first region MF1 due to development can be suppressed. As a result, according to the method MT2, it is possible to reduce the exposure dose required to obtain the desired dimension (for example, a line width). That is, according to the method MT2, it is possible to improve the sensitivity. In addition, according to the method MT2, the roughness of the developed metal-containing film MF can be reduced.

In one embodiment, a length of the processing time in the operation ST22 may be shorter than a length of the processing time in the operation ST23. In an example, a value of a ratio of the length of the processing time of the operation ST22 to the length of the processing time of the operation ST23 may be controlled to be 0.5 or less or 0.3 or less. In a case where the value of the ratio of the length of the processing time of the operation ST22 to the length of the processing time of the operation ST23 is 0.5 or less or 0.3 or less, it is possible to sufficiently suppress roughness deterioration and/or the development defects such as scum.

In one embodiment, a cycle including the operation ST22 and the operation ST23 may be repeated a plurality of times. In this case, after the operation ST22 is performed, the operation ST23 may be performed, and the execution period of the operation ST22 and the execution period of the operation ST23 may partially overlap.

In addition, in a case where the cycle including the operation ST22 and the operation ST23 is repeated a plurality of times, the value of the ratio of the flow rate of the gas including a Lewis acid to the flow rate of the development gas may be changed in the operation ST23 of each cycle or in the operation ST23 of the specific cycle. Furthermore, in a case where the cycle including the operation ST22 and the operation ST23 is repeated a plurality of times, the value of the ratio of the flow rate of the gas including a Lewis acid to the flow rate of the development gas may be changed for each cycle.

The method MT2 may include the operation ST24 of determining whether or not the substrate W after the operation ST23 satisfies a predetermined condition. The predetermined condition may be the removal amount of the second region MF2, may be the presence or absence of the exposure of the underlying film UF, or may be the processing time in the operation ST22 and the operation ST23. In a case where it is determined in the operation ST24 that the predetermined condition is not satisfied (in a case where the determination result in the operation ST24 of FIG. 13 is "NO"), the operation ST22 may be performed again. On the other hand, in a case where it is determined in the operation ST24 that the predetermined condition is satisfied (in a case where the determination result in the operation ST24 of FIG. 13 is "YES"), the method MT2 may end.

### <Configuration Example of Substrate Processing System>

FIG. 14 is a block diagram for describing a configuration example of the substrate processing system SS according to an example embodiment. The substrate processing system SS includes a first carrier station CS1, a first processing station PS1, a first interface station IS1, an exposure device EX, a second interface station IS2, a second processing station PS2, a second carrier station CS2, and a controller CT.

The first carrier station CS1 performs the transferring-in and transferring-out of a first carrier C1 between the first carrier station CS1 and a system external to the substrate processing system SS. The first carrier station CS1 has a placing stand having a plurality of first placing plates ST1. The first carrier C1 in a state where a plurality of substrates W are accommodated therein or in a state where the first carrier C1 is empty is placed on each first placing plate ST1. The first carrier C1 has a housing capable of accommodating the plurality of substrates W inside. In one example, the first carrier C1 is a front opening unified pod (FOUP).

In addition, the first carrier station CS1 transfers the substrate W between the first carrier C1 and the first processing station PS1. The first carrier station CS1 further includes a first transfer device HD1. The first transfer device HD1 is disposed in the first carrier station CS1 to be positioned between the placing stand and the first processing station PS1. The first transfer device HD1 transfers and delivers the substrate W between the first carrier C1 on each first placing plate ST1 and a second transfer device HD2 of the first processing station PS1. The substrate processing system SS may further include a load lock module. The load lock module may be disposed between the first carrier station CS1 and the first processing station PS1. The load lock module can switch the pressure inside the load lock module to atmospheric pressure or vacuum. The "atmospheric pressure" may be a pressure inside the first transfer device HD1. The "vacuum" may be a pressure lower than atmospheric pressure, for example, a medium vacuum of 0.1 Pa to 100 Pa. The inside of the second transfer device HD2 may be atmospheric pressure or vacuum. For example, the load lock module may be used when transferring the substrate W from the first transfer device HD1, which is atmospheric pressure, to the second transfer device HD2, which is vacuum, and transferring the substrate W from the second transfer device HD2, which is vacuum, to the first transfer device HD1, which is atmospheric pressure.

The first processing station PS1 performs various types of processing on the substrate W. In one embodiment, the first processing station PS1 includes a pre-processing module PM1, a resist film forming module PM2, and a first heat treatment module PM3 (hereinafter, also collectively referred to as a "first substrate processing module PMa"). In addition, the first processing station PS1 has a second transfer device HD2 for transferring the substrate W. The second transfer device HD2 transfers and delivers the substrate W between the two designated first substrate processing modules PMa and between the first processing station PS1 and the first carrier station CS1 or the first interface station IS1.

In the pre-processing module PM1, the substrate W is subjected to the preprocessing. In one embodiment, the pre-processing module PM1 includes a temperature adjustment unit that adjusts the temperature of the substrate W, a high-precision temperature adjustment unit that adjusts the temperature of the substrate W with high precision, and the like. In one embodiment, the pre-processing module PM1 includes a surface reforming processing unit that performs surface reforming processing on the substrate W. Each processing unit of the pre-processing module PM1 may be configured to include a heat treatment apparatus 100 (refer to FIG. 1) and a plasma processing apparatus 1 (refer to FIGS. 2 and 3).

In the resist film forming module PM2, a resist film is formed on the substrate W. In one embodiment, the resist film forming module PM2 includes a dry coating unit. The dry coating unit forms a resist film on the substrate W by using a dry process such as a vapor deposition method. In one example, the dry coating unit includes a CVD device or ALD device that performs chemical vapor deposition of a resist film on the substrate W disposed in the chamber, or a PVD device that performs physical vapor deposition of a resist film on the substrate W disposed in the chamber. The dry coating unit may be the heat treatment apparatus 100 (refer to FIG. 1) or the plasma processing apparatus 1 (refer to FIGS. 2 and 3).

In one embodiment, the resist film forming module PM2 includes a wet coating unit. The wet coating unit forms a resist film on the substrate W by using a wet process such as a solution coating method.

In one embodiment, an example of the resist film forming module PM2 includes both the wet coating unit and the dry coating unit. The resist film forming module PM2 can form a film in a state before the exposure of the metal-containing film MF described above as the resist film.

In the first heat treatment module PM3, the substrate W is subjected to the heat treatment. In one embodiment, the first heat treatment module PM3 includes any one or more of a pre bake (PAB) unit that performs a heating treatment on the substrate W on which the resist film is formed, a temperature adjustment unit that adjusts the temperature of the substrate W, and a high-precision temperature adjustment unit that adjusts the temperature of the substrate W with high precision. Each of these units may have one or a plurality of heat treatment apparatuses. In one example, the plurality of heat treatment apparatuses may be stacked. For example, the heat treatment apparatus may be the heat treatment apparatus 100 (refer to FIG. 1). Each heat treatment may be performed at a predetermined temperature by using a predetermined gas.

The first interface station IS1 has a third transfer device HD3. The third transfer device HD3 transfers and delivers the substrate W between the first processing station PS1 and the exposure device EX. The third transfer device HD3 may be configured to have a housing that accommodates the substrate W, and may be configured such that the temperature, humidity, pressure, and the like in the housing are controllable.

In the exposure device EX, the resist film on the substrate W is exposed by using an exposure mask (reticle). The exposure device EX may be, for example, an EUV exposure device having a light source generating EUV light.

The second interface station IS2 has a fourth transfer device HD4. The fourth transfer device HD4 transfers and delivers the substrate W between the exposure device EX and the second processing station PS2. The fourth transfer device HD4 may be configured to have a housing that accommodates the substrate W, and may be configured such that the temperature, humidity, pressure, and the like in the housing are controllable.

The second processing station PS2 performs various types of processing on the substrate W. In one embodiment, the second processing station PS2 includes a second heat treatment module PM4, a measurement module PM5, a development module PM6, and a third heat treatment module PM7 (hereinafter, also collectively referred to as a "second substrate processing module PMb"). In addition, the second processing station PS2 has a fifth transfer device HD5 for transferring the substrate W. The fifth transfer device HD5 transfers and delivers the substrate W between the two designated second substrate processing modules PMb and between the second processing station PS2 and the second carrier station CS2 or the second interface station IS2.

In the second heat treatment module PM4, the substrate W is subjected to the heat treatment. In one embodiment, the second heat treatment module PM4 includes any one or more of a post exposure bake (PEB) unit that performs a heating treatment on the substrate W after exposure, a temperature adjustment unit that adjusts the temperature of the substrate W, and a high-precision temperature adjustment unit that adjusts the temperature of the substrate W with high precision. Each of these units may have one or a plurality of heat treatment apparatuses. In one example, the plurality of heat treatment apparatuses may be stacked. For example, the heat treatment apparatus may be the heat treatment apparatus 100 (refer to FIG. 1). Each heat treatment may be performed at a predetermined temperature by using a predetermined gas.

In the measurement module PM5, various measurements are performed on the substrate W. In one embodiment, the measurement module PM5 includes an imaging unit including a placing stand on which the substrate W is placed, an imaging device, an illumination device, and various sensors (a temperature sensor, a reflectivity measuring sensor, and the like). For example, the imaging device may be a CCD camera that images the appearance of the substrate W. Alternatively, the imaging device may be a hyperspectral camera that takes an image by spectrally separating light for each wavelength. The hyperspectral camera can measure any one or more of a pattern shape, a dimension, a film thickness, a composition, and a film density of a resist film.

In the development module PM6, the substrate W is subjected to the development processing. In one embodiment, the development module PM6 includes a dry development unit that performs dry development on the substrate W. The dry development unit may be, for example, the heat treatment apparatus 100 (refer to FIG. 1) or the plasma processing apparatus 1 (refer to FIGS. 2 and 3).

In the third heat treatment module PM7, the substrate W is subjected to the heat treatment. In one embodiment, the third heat treatment module PM7 includes any one or more of a post bake (PB) unit that performs a heating treatment on the substrate W after development, a temperature adjustment unit that adjusts the temperature of the substrate W, and a high-precision temperature adjustment unit that adjusts the temperature of the substrate W with high precision. Each of these units may have one or a plurality of heat treatment apparatuses. In one example, the plurality of heat treatment apparatuses may be stacked. For example, the heat treatment apparatus may be the heat treatment apparatus 100 (refer to FIG. 1). Each heat treatment may be performed at a predetermined temperature by using a predetermined gas.

The second carrier station CS2 performs the transferring-in and transferring-out of a second carrier C2 between the second carrier station CS2 and a system external to the substrate processing system SS. The configuration and the function of the second carrier station CS2 may be the same as those of the above-described first carrier station CS1.

The controller CT controls each component of the substrate processing system SS to perform given processing on the substrate W. The controller CT stores a recipe in which a procedure of the process, a condition of the process, a transfer condition, and the like are set, and controls each component of the substrate processing system SS such that the given processing is performed on the substrate W according to the recipe. The controller CT may have some or all of the functions of each controller (the controller 200 and the controller 2) shown in FIGS. 1 to 3.

### <Example of Substrate Processing Method>

FIG. 15 is a flowchart showing a substrate processing method (hereinafter, also referred to as a "method MT") according to an example embodiment. As shown in FIG. 15, the method MT includes an operation ST100 of subjecting a substrate to preprocessing, an operation ST200 of forming a resist film on the substrate, an operation ST300 of subjecting the substrate on which the resist film is formed to a heating treatment (pre bake: PAB), an operation ST400 of subjecting the substrate to EUV exposure, an operation ST500 of subjecting the substrate after the exposure to a heating treatment (post exposure bake: PEB), an operation ST600 of measuring the substrate, an operation ST700 of developing the resist film on the substrate, an operation ST800 of subjecting the substrate after the development to a heating treatment (post bake: PB), and an operation ST900 of etching the substrate. The method MT may not include one or more of the above-described respective operations. For example, the method MT may not include the operation ST600, and the operation ST700 may be performed after the operation ST500.

The method MT may be executed by using the substrate processing system SS shown in FIG. 14. In the following, a case where the controller CT of the substrate processing system SS controls each component of the substrate processing system SS to perform the method MT on the substrate W will be described as an example.

### (Operation ST100: Preprocessing)

First, the first carrier C1 accommodating the plurality of substrates W is transferred into the first carrier station CS1 of the substrate processing system SS. The first carrier C1 is placed on the first placing plate ST1. Next, each substrate W in the first carrier C1 is sequentially taken out by the first transfer device HD1, and delivered to the second transfer device HD2 of the first processing station PS1. The substrate W is transferred to the pre-processing module PM1 by the second transfer device HD2. The pre-processing module PM1 performs the preprocessing on the substrate W. The preprocessing may include, for example, one or more of temperature adjustment of the substrate W, formation of some or all of an underlying film of the substrate W, a heating treatment of the substrate W, and high-precision temperature adjustment of the substrate W. The preprocessing may include the surface reforming processing of the substrate W.

### (Operation S200: Resist Film Formation)

Next, the substrate W is transferred to the resist film forming module PM2 by the second transfer device HD2. The resist film is formed on the substrate W by the resist film forming module PM2. In one embodiment, the formation of the resist film is performed by a wet process such as a liquid phase deposition method. For example, the resist film is formed by spin-coating the resist film on the substrate W using the wet coating unit of the resist film forming module PM2. In one embodiment, the formation of the resist film on the substrate W is performed by a dry process such as a vapor deposition method. For example, the resist film is formed by vapor-depositing the resist film on the substrate W using the dry coating unit of the resist film forming module PM2.

The formation of the resist film on the substrate W may be performed by using both the dry process and the wet process. For example, the second resist film may be formed on the first resist film by the wet process after the first resist film is formed on the substrate W by the dry process. In this case, the film thicknesses, materials, and/or compositions of the first resist film and the second resist film may be the same as or different from each other.

### (Operation ST300: PAB)

Next, the substrate W is transferred to the first heat treatment module PM3 by the second transfer device HD2. The substrate W is subjected to a heating treatment (pre bake: PAB) by the first heat treatment module PM3. The pre bake may be performed in an air atmosphere or an inert atmosphere. In addition, the pre bake may be performed by heating the substrate W to 50°C or higher and 250°C or lower, 50°C or higher and 200°C or lower, or 80°C or higher and 150°C or lower. In the operation ST200, in a case where the resist film is formed by the dry process, in one embodiment, the pre bake may be continuously performed by the dry coating unit that has performed the operation ST200. In one embodiment, after the pre bake, processing of removing the resist film at the edge of the substrate W (edge bead removal: EBR) may be performed.

### (Operation ST400: EUV Exposure)

Next, the substrate W is delivered to the third transfer device HD3 of the first interface station IS1 by the second transfer device HD2. Then, the substrate W is transferred to the exposure device EX by the third transfer device HD3. The substrate W is subjected to EUV exposure via the exposure mask (reticle) in the exposure device EX. As a result, on the substrate W, a first region where EUV exposure is performed and a second region where EUV exposure is not performed are formed corresponding to a pattern of the exposure mask (reticle).

### (Operation ST500: PEB)

Next, the substrate W is transferred from the fourth transfer device HD4 of the second interface station IS2 to the fifth transfer device HD5 of the second processing station PS2. The substrate W is then transferred to the second heat treatment module PM4 by the fifth transfer device HD5. The substrate W is then subjected to a heating treatment (post exposure bake: PEB) in the second heat treatment module PM4. The post exposure bake may be performed in an air atmosphere. In addition, the post exposure bake may be performed by heating the substrate W to 120°C or higher and 250°C or lower.

### (Operation ST600: Measurement)

Next, the substrate W is transferred to the measurement module PM5 by the fifth transfer device HD5. The measurement module PM5 measures the substrate W. The measurement may be an optical measurement or another measurement. In one embodiment, the measurement by the measurement module PM5 includes measuring the appearance and/or the dimensions of the substrate W using a CCD camera. In one embodiment, the measurement by the measurement module PM5 includes measuring any one or more of a pattern shape, a dimension, a film thickness, a composition, or a film density of the resist film using the hyperspectral camera (hereinafter, also referred to as "pattern shape or the like").

In one embodiment, the controller CT determines the presence or absence of the exposure abnormality of the substrate W based on the measured appearance, dimension, and/or pattern shape of the substrate W. In one embodiment, in a case where the controller CT determines that an exposure abnormality is present, the substrate W may be reworked or discarded without performing the development in the operation ST700. The rework of the substrate W may be performed by removing the resist on the substrate W and returning to the operation ST200 to form a resist film again. Rework after development may cause damage to the substrate W, but damage to the substrate W can be avoided or suppressed by performing rework before the development.

### (Operation ST700: Development)

Next, the substrate W is transferred to the development module PM6 by the fifth transfer device HD5. In the development module PM6, the resist film of the substrate W is developed. The development processing may be performed by dry development. The development processing in the operation ST700 may be performed by the method MT1 or the method MT2. Desorption processing may be performed once or more after the development processing or during the development processing. The desorption processing includes removing (descumming) a scum from the surface of the resist film and the surface of the underlying film UF or smoothing the surface with an inert gas such as helium or a plasma of the inert gas. In addition, in the development module PM6, after the development processing, a part of the underlying film UF may be etched using the developed metal-containing film MF as a mask.

### (Operation ST800: PB)

Next, the substrate W is transferred to the third heat treatment module PM7 by the fifth transfer device HD5 and is subjected to the heating treatment (post bake). The post bake may be performed in an air atmosphere or a reduced pressure atmosphere containing N₂ or O₂. In addition, the post bake may be performed by heating the substrate W to 150°C or higher and 250°C or lower. The post bake may be performed by the second heat treatment module PM4 instead of the third heat treatment module PM7. In one embodiment, the optical measurement of the substrate W may be performed by the measurement module PM5 after the post bake. Such measurement may be performed in addition to the measurement in the operation ST600 or instead of the measurement in the operation ST600. In one embodiment, the controller CT determines the presence or absence of an abnormality such as a defect, a scratch, or an adhesion of a foreign substance in the developed pattern of the substrate W based on the measured appearance, dimensions, and/or pattern shape of the substrate W, and the like. In one embodiment, in a case where the controller CT determines that an abnormality is present, the substrate W may be reworked or discarded without performing the etching in the operation ST900. In one embodiment, in a case where the controller CT determines that an abnormality is present, an opening dimension of the resist film of the substrate W may be adjusted by using the dry coating unit (CVD device, ALD device, or the like).

### (Operation ST900: Etching)

After the operation ST800 is performed, the substrate W is delivered to a sixth transfer device HD6 of the second carrier station CS2 by the fifth transfer device HD5, and is transferred to the second carrier C2 of the second placing plate ST2 by the sixth transfer device HD6. Thereafter, the second carrier C2 is transferred to the plasma processing system (not shown). In the plasma processing system, the underlying film UF of the substrate W is etched using the resist film after development as a mask. With this, the method MT ends. In the operation ST700, in a case where the resist film is developed using the plasma processing apparatus, the etching may be continuously performed in the plasma processing chamber of the plasma processing apparatus. In addition, in a case where the second processing station PS2 includes a plasma processing module in addition to the development module PM6, the etching may be performed in the plasma processing module. The above-described desorption processing may be performed once or more before the etching or during the etching.

In the following, timing charts related to the method MT1 and the method MT2 will be described with reference to (a) of FIG. 16, (b) of FIG. 16, FIG. 17, and FIG. 18. (a) of FIG. 16 and (b) of FIG. 16 are timing charts of an example of the development processing performed according to any one of the method MT1 and the method MT2. Each of FIG. 17 and FIG. 18 is a timing chart of an example of development processing performed according to the method MT2.

As shown in (a) of FIG. 16, in the operation ST12 of the method MT1, the Lewis acid gas and the development gas (for example, HBr gas) may be supplied at the same time into the chamber (that is, toward the substrate). As shown in (b) of FIG. 16, in the operation ST22 of the method MT2, a first processing gas including the Lewis acid gas may be supplied into the chamber. In the subsequent operation ST23, a second processing gas including the Lewis acid gas and the development gas may be supplied into the chamber, that is, to the substrate W. In the examples shown in each of (a) of FIG. 16 and (b) of FIG. 16, the supply of the Lewis acid gas and the supply of the development gas are stopped at the same time, but the supply of the development gas may be stopped after the supply of the Lewis acid gas is stopped.

As shown in FIGS. 17 and 18, the operation ST22 and the operation ST23 of the method MT2 may be alternately performed. As shown in FIGS. 17 and 18, the operation ST22 is performed before the operation ST23. The period of the operation ST22 and the period of Operation ST23 may not overlap each other, or may partially overlap each other.

In the examples shown in each of FIGS. 17 and 18, a flow rate of the Lewis acid gas supplied into the chamber in the operation ST22 is set to a flow rate L2. On the other hand, a flow rate of the development gas in the operation ST22 is set to D1. In the operation ST23, the flow rate of the development gas supplied into the chamber is set to a flow rate D2. On the other hand, the flow rate of the Lewis acid gas in the operation ST23 is set to L1. The flow rate L1 is smaller than the flow rate L2. The flow rate L1 may be zero or may be greater than zero. In addition, the flow rate D1 is smaller than the flow rate D2. The flow rate D1 may be zero or may be greater than zero. A length of the time of the operation ST22 and/or a length of the time of the operation ST23 may be changed according to the elapsed time of the development processing. For example, the length of the time of the operation ST22 may increase as the development processing progresses. In addition, the flow rate L2 and/or the flow rate D2 may be changed according to the elapsed time of the development processing. For example, the flow rate D2 may be decreased to a flow rate smaller than the flow rate L2 as the development processing progresses.

As shown in FIG. 17, a temperature of the substrate support may be adjusted to a temperature T1 between the alternately repeated the operation ST22 and the operation ST23. Alternatively, as shown in FIG. 18, the temperature of the substrate support may be set to the temperature T1 in a period in which the operation ST22 and the subsequent operation ST23 are performed, and the operation ST25 of adjusting the temperature of the substrate support to a temperature T2 higher than the temperature T1 may be performed between the operation ST23 and the subsequent operation ST22. That is, the cycle including the operation ST22, the operation ST23, and the operation ST25 may be repeated. In this case, it is possible to perform the development while removing residues (scum) on the substrate W in the operation ST25. The period of the operation ST25 may not overlap with the period of the operation ST22 and the period of the operation ST23, or may partially overlap with the period of the operation ST22 and the period of the operation ST23.

Although the various example embodiments have been described above, various additions, omissions, substitutions, and changes may be made without being limited to the example embodiments described above. In addition, other embodiments can be formed by combining elements in different embodiments.

In the following, experiments performed for evaluating the substrate processing method according to various example embodiments will be described.

### (First Experiment)

In the first experiment, the entire region of the metal-containing film was exposed with light, and then the metal-containing film was exposed to the processing gas. The metal-containing film was a resist film that contains tin oxide. As the processing gas, two kinds of processing gases were individually used. One of the two types of processing gases was a processing gas containing only an HBr gas, and the other processing gas was a processing gas including an HBr gas and a BCl₃ gas. Then, a film thickness of the metal-containing film after the processing using the processing gas, that is, a residual film amount was measured.

FIG. 19 shows results of the first experiment. In the graph of FIG. 19, a horizontal axis indicates an exposure dose, and a vertical axis indicates a residual film amount (film remain) of the metal-containing film after processing using a processing gas. In the graph of FIG. 19, "HBr Only" shows the result in a case where a processing gas including only HBr gas was used, and "HBr & BCl_{3"} shows the result in a case where a processing gas including HBr gas and BCl₃ gas was used. As shown in FIG. 19, the residual film amount in a case where the processing gas including the HBr gas and the BCl₃ gas was used was larger than the residual film amount in a case where the processing gas including only the HBr gas was used. From this result, it is confirmed that the sensitivity is improved by using the processing gas including the HBr gas and the BCl₃ gas, that is, the processing gas including the development gas and the Lewis acid gas.

### (Second Experiment)

In the second experiment, the entire region of the metal-containing film was exposed with light, and then the metal-containing film was exposed to the processing gas. The metal-containing film was a resist film that contains tin oxide. As the processing gas, two kinds of processing gases were individually used. One of the two types of processing gases was a processing gas containing only an HBr gas, and the other processing gas was a processing gas including an HBr gas and a BCl₃ gas. In the processing gas including the HBr gas and the BCl₃ gas, a ratio of flow rate (flow rate of HBr gas:flow rate of BCl₃ gas) was 10:1. Then, a film thickness of the metal-containing film after the processing using the processing gas, that is, a residual film amount was measured.

FIG. 20 shows results of the second experiment. In the graph of FIG. 20, a horizontal axis indicates an exposure dose, and a vertical axis indicates a residual film amount (film remain) of the metal-containing film after processing using a processing gas. In the graph of FIG. 20, "HBr Only" indicates the result in a case where a processing gas including only the HBr gas was used. "HBr:BCl₃ = 10:1 (BCl₃ added first)" shows the results in a case where only the BCl₃ gas was supplied first, and then the processing gas including the HBr gas and the BCl₃ gas was supplied. "HBr:BCl₃ = 10: 1 (BCl₃ added simultaneously)" indicates the result in a case where the supply of the HBr gas and the supply of the BCl₃ gas were started at the same time. "HBr:BCl₃ = 10:1 (BCl₃ added later)" indicates the results in a case where only the HBr gas was supplied and then the processing gas including the HBr gas and the BCl₃ gas was supplied. As shown in FIG. 20, in a case where the BCl₃ gas was supplied earlier than the HBr gas and in a case where the supply of the HBr gas and the supply of the BCl₃ gas were started at the same time, the residual film amount is larger than the residual film amount in other cases. From this result, it is confirmed that the sensitivity is improved by supplying the BCl₃ gas earlier than the HBr gas or starting the supply of the HBr gas and the supply of the BCl₃ gas at the same time, that is, by supplying the Lewis acid gas earlier than the development gas or starting the supply of the development gas and the supply of the Lewis acid gas at the same time.

### (Third Experiment)

In the third experiment, the entire region of the metal-containing film was exposed with light, and then the metal-containing film was exposed to the processing gas. The metal-containing film was a resist film that contains tin oxide. As the processing gas, four types of processing gases were individually used. Among the four types of processing gases, a first gas included an HBr gas and a BCl₃ gas, and a ratio of the flow rate of the first gas (flow rate of HBr gas:flow rate of BCl₃ gas) was 10:7. Among the four types of processing gases, a second gas included an HBr gas and a BCl₃ gas, and a ratio of the flow rate of the second gas (flow rate of HBr gas:flow rate of BCl₃ gas) was 10:4. Among the four types of processing gases, a third gas included an HBr gas and a BCl₃ gas, and a ratio of the flow rate of the third gas (flow rate of HBr gas:flow rate of BCl₃ gas) was 10:1. A fourth gas among the four types of processing gases was a processing gas including only the HBr gas. Then, a film thickness of the metal-containing film after the processing using the processing gas, that is, a residual film amount was measured.

FIG. 21 shows results of the third experiment. In the graph of FIG. 21, a horizontal axis indicates an exposure dose, and a vertical axis indicates a residual film amount (film remain) of the metal-containing film after processing using a processing gas. In the graph of FIG. 21, "HBr:BCl₃ = 10:7", "HBr:BCl₃ = 10:4", "HBr:BCl₃ = 10:1", and "HBr:BCl₃ = 10:0 (HBr Only)" show the results in a case where each of the first to fourth gases was used. As shown in FIG. 21, in any case of the ratio of the flow rate of 10:7, 10:4, and 10:1, the residual film amount was larger than the residual film amount in a case where the processing gas including only the HBr gas was used. From this result, it is confirmed that high sensitivity can be obtained in a case where a value of a ratio of the flow rate of the BCl₃ gas to the flow rate of the HBr gas is in a range of 0.1 or more and 0.7 or less.

### (Fourth Experiment)

In the fourth experiment, a line-and-space pattern was formed by exposing the metal-containing film with EUV light and then exposing the metal-containing film to the processing gas. The metal-containing film was a resist film that contains tin oxide. As the processing gas, two kinds of processing gases were individually used. One of the two types of processing gases was a processing gas containing only an HBr gas, and the other processing gas was a processing gas including an HBr gas and a BCl₃ gas. Then, a difference ΔCD between the maximum width and the minimum width in a cross section of a line portion in the line-and-space pattern was obtained. Then, a value ΔCDn obtained by normalizing a difference ΔCD in a case of using the processing gas including the HBr gas and the BCl₃ gas with a difference ΔCD in a case of using the processing gas including only the HBr gas was obtained. As a result, the value ΔCDn is 0.78. From this result, it is confirmed that the first region MF1 having high verticality can be obtained by using the processing gas including the HBr gas and the BCl₃ gas, that is, by using the processing gas including the Lewis acid gas and the development gas.

### (Fifth Experiment)

In the fifth experiment, a line-and-space pattern was formed by exposing the metal-containing film with EUV light and then exposing the metal-containing film to the processing gas. The metal-containing film was a resist film that contains tin oxide. As the processing gas, four types of processing gases are individually used. The first gas among the four types of processing gases was a gas including the HBr gas and an O₂ gas. The second gas among the four types of processing gases was a gas including the HBr gas and an SO₂ gas. The third gas among the four types of processing gases was a gas including the HBr gas and the BCl₃ gas. The fourth gas among the four types of processing gases was a gas including only the HBr gas. In addition, in a case where each of the four types of processing gases was used, an exposure dose (mJ/cm²) required for forming a line-and-space pattern including a line portion having a line width of 16 nm was specified. Then, a value, that is, a normalized exposure dose, in which the exposure dose required in a case where each of the first to third gases was used is normalized by the exposure dose required in a case where the fourth gas was used, was obtained. As a result, the normalized exposure doses in a case where the first to third gases were used were 0.92, 0.87, and 0.90. From this result, it is confirmed that the sensitivity is improved by using any one of the first to third gases, that is, the processing gas including the Lewis acid gas and the development gas. In addition, the LWR of the line portion obtained in a case where each of the third gas and the fourth gas was used is obtained. Then, a value, that is, the normalized LWR, is obtained by normalizing the LWR in a case where the third gas was used with the LWR in a case where the fourth gas was used. The obtained normalized LWR was 0.98. From this result, it is confirmed that the roughness is improved by using the processing gas including the HBr gas and the BCl₃ gas.

Here, various examples in the disclosure are described in the following [E1] to [E19].

### [E1]

A substrate processing method including:
(a) providing a substrate on a substrate support in a chamber, the substrate having a metal-containing film including an exposed first region and an unexposed second region; and
(b) exposing the substrate to BCl₃ gas and HBr gas to selectively remove the second region with respect to the first region to form a recess in the metal-containing film.

### [E2]

The substrate processing method according to E1, wherein
in the (b), a temperature of the substrate support is set to 100°C or lower.

### [E3]

The substrate processing method according to E1, wherein
in the (b), a protective portion containing boron is formed on a side wall defining the recess.

### [E4]

The substrate processing method according to E1, wherein
in the (b), a bond of boron and oxygen is formed on a side wall defining the recess.

### [E5]

The substrate processing method according to any one of E1 to E4, wherein
the (b) includes simultaneously supplying the BCl₃ gas and the HBr gas into the chamber.

### [E6]

The substrate processing method according to any one of E1 to E4, wherein
the (b) includes
(b-1) supplying the BCl₃ gas into the chamber prior to supplying the HBr gas, and
(b-2) supplying the HBr gas after the (b-1).

### [E7]

The substrate processing method according to E6, wherein
a length of time during which the (b-1) is performed is shorter than a length of time during which the (b-2) is performed.

### [E8]

The substrate processing method according to any one of E1 to E7, wherein
a flow rate of the HBr gas is greater than a flow rate of the BCl₃ gas.

### [E9]

The substrate processing method according to any one of E1 to E7, wherein
a value of a ratio of a flow rate of the BCl₃ gas to a flow rate of the HBr gas is 0.1 or more.

### [E10]

The substrate processing method according to E9, wherein
the value of the ratio is 0.7 or less.

### [E11]

The substrate processing method according to any one of E1 to E10, wherein
the metal-containing film contains at least one selected from the group consisting of tin, hafnium, and titanium.

### [E12]

A substrate processing method including:
(a) providing a substrate on a substrate support in a chamber, the substrate having a metal-containing film including an exposed first region and an unexposed second region; and
(b) selectively removing the second region with respect to the first region to form a recess in the metal-containing film,

wherein the (b) includes
   (b-1) exposing the substrate to a first processing gas including a Lewis acid gas in a first period, and
   (b-2) exposing the substrate to a second processing gas including a development gas in a second period, and
the second period starts at a time point of start of the first period or after the time point of start of the first period.

### [E13]

The substrate processing method according to E12, wherein
the second processing gas further includes the Lewis acid gas, and
in the second period, a flow rate of the development gas is greater than a flow rate of the Lewis acid gas.

### [E14]

The substrate processing method according to E12 or E13, wherein
a value of a ratio of a flow rate of the Lewis acid gas to a flow rate of the development gas is 0.1 or more.

### [E15]

The substrate processing method according to E14, wherein the value of the ratio is 0.7 or less.

### [E16]

The substrate processing method according to any one of E12 to E15, further including:
repeating the (b-1) and the (b-2) alternately.

### [E17]

The substrate processing method according to any one of E12 to E16, wherein
the Lewis acid gas contains at least one selected from the group consisting of BX₃, AlX₃, FeX₃, GaX₃, SbX₅, InX₃, SO₂, and SO₃, where X is F, Br, I, H, R, or OR, R is a methyl group, an ethyl group, a propyl group, a butyl group, an isopropyl group, an isobutyl group, a sec-butyl group, or a tert-butyl group, and OR is a methoxy group, an ethoxy group, a propoxy group, a butoxy group, an isopropoxy group, an isobutoxy group, a sec-butoxy group, or a tert-butoxy group.

### [E18]

The substrate processing method according to any one of E12 to E17, wherein
the development gas contains at least one selected from the group consisting of HBr, HCl, and a carboxylic acid.

### [E19]

A substrate processing system including:
a chamber;
a substrate support disposed in the chamber;
a gas supply configured to supply a gas into the chamber; and
a controller configured to control the gas supply,
wherein the controller is configured to, in a state where a substrate having a metal-containing film including an exposed first region and an unexposed second region is placed on the substrate support, expose the substrate to BCl₃ gas and HBr gas from the gas supply to selectively remove the second region with respect to the first region to form a recess in the metal-containing film.

From the foregoing description, it will be understood that various embodiments of the present disclosure have been described in the present specification for purposes of illustration, and that various modifications may be made without departing from the scope and spirit of the present disclosure. Accordingly, the various embodiments disclosed in the present specification are not intended to be limiting, with the true scope and spirit being indicated by the following claims.

### Reference Signs List

1: plasma processing apparatus
2: controller
10: plasma processing chamber
11: substrate support
20: gas supply
30: power supply
100: heat treatment apparatus
102: processing chamber
120: stage heater
121: substrate support
141: gas nozzle
200: controller
MF: metal-containing film
MF1: first region
MF2: second region
UF: underlying film
W: substrate
PF: protective portion

## Claims

1. A substrate processing method comprising:
(a) providing a substrate on a substrate support in a chamber, the substrate having a metal-containing film including an exposed first region and an unexposed second region; and
(b) exposing the substrate to BCl₃ gas and HBr gas to selectively remove the second region with respect to the first region to form a recess in the metal-containing film.

2. The substrate processing method according to Claim 1, wherein
in the (b), a temperature of the substrate support is set to 100°C or lower.

3. The substrate processing method according to Claim 1, wherein
in the (b), a protective portion containing boron is formed on a side wall defining the recess.

4. The substrate processing method according to Claim 1, wherein
in the (b), a bond of boron and oxygen is formed on a side wall defining the recess.

5. The substrate processing method according to any one of Claims 1 to 4, wherein
the (b) includes simultaneously supplying the BCl₃ gas and the HBr gas into the chamber.

6. The substrate processing method according to any one of Claims 1 to 4, wherein
the (b) includes
(b-1) supplying the BCl₃ gas into the chamber prior to supplying the HBr gas, and
(b-2) supplying the HBr gas after the (b-1).

7. The substrate processing method according to Claim 6, wherein
a length of time during which the (b-1) is performed is shorter than a length of time during which the (b-2) is performed.

8. The substrate processing method according to any one of Claims 1 to 4, wherein
a flow rate of the HBr gas is greater than a flow rate of the BCl₃ gas.

9. The substrate processing method according to any one of Claims 1 to 4, wherein
a value of a ratio of a flow rate of the BCl₃ gas to a flow rate of the HBr gas is 0.1 or more.

10. The substrate processing method according to Claim 9, wherein
the value of the ratio is 0.7 or less.

11. The substrate processing method according to any one of Claims 1 to 4, wherein
the metal-containing film contains at least one selected from the group consisting of tin, hafnium, and titanium.

12. A substrate processing method comprising:
(a) providing a substrate on a substrate support in a chamber, the substrate having a metal-containing film including an exposed first region and an unexposed second region; and
(b) selectively removing the second region with respect to the first region to form a recess in the metal-containing film,
wherein the (b) includes
(b-1) exposing the substrate to a first processing gas including a Lewis acid gas in a first period, and
(b-2) exposing the substrate to a second processing gas including a development gas in a second period, and
the second period starts at a time point of start of the first period or after the time point of start of the first period.

13. The substrate processing method according to Claim 12, wherein
the second processing gas further includes the Lewis acid gas, and
in the second period, a flow rate of the development gas is greater than a flow rate of the Lewis acid gas.

14. The substrate processing method according to Claim 12, wherein
a value of a ratio of a flow rate of the Lewis acid gas to a flow rate of the development gas is 0.1 or more.

15. The substrate processing method according to Claim 14, wherein the value of the ratio is 0.7 or less.

16. The substrate processing method according to any one of Claims 12 to 15, further comprising:
repeating the (b-1) and the (b-2) alternately.

17. The substrate processing method according to Claim 12, wherein
the Lewis acid gas contains at least one selected from the group consisting of BX₃, AlX₃, FeX₃, GaX₃, SbX₅, InX₃, SO₂, and SO₃, where X is F, Br, I, H, R, or OR, R is a methyl group, an ethyl group, a propyl group, a butyl group, an isopropyl group, an isobutyl group, a sec-butyl group, or a tert-butyl group, and OR is a methoxy group, an ethoxy group, a propoxy group, a butoxy group, an isopropoxy group, an isobutoxy group, a sec-butoxy group, or a tert-butoxy group.

18. The substrate processing method according to any one of Claims 12 to 15 and 17, wherein
the development gas contains at least one selected from the group consisting of HBr, HCl, and a carboxylic acid.

19. A substrate processing system comprising:
a chamber;
a substrate support disposed in the chamber;
a gas supply configured to supply a gas into the chamber; and
a controller configured to control the gas supply,
wherein the controller is configured to, in a state where a substrate having a metal-containing film including an exposed first region and an unexposed second region is placed on the substrate support, expose the substrate to BCl₃ gas and HBr gas from the gas supply to selectively remove the second region with respect to the first region to form a recess in the metal-containing film.
